# EUROPÄISCHE PATENTSCHRIFT

(11) **EP 1 838 640 B1**
(45) Veröffentlichungstag und Bekanntmachung des Hinweises auf die Patenterteilung: **05.08.2009**
(21) Anmeldenummer: 05819417.6
(22) Anmeldetag: 19.12.2005
(51) Int. Cl.: C03C 17/245, C03C 17/34, C03C 23/00, C23C 14/22, C23C 16/44

(54) **FEINLAMINARE BARRIERESCHUTZSCHICHT**
FINE-LAMINAR BARRIER PROTECTION LAYER
COUCHE DE PROTECTION BARRIERE LAMINAIRE FINE

(30) Priorität: 17.12.2004 DE 102004061464
(43) Veröffentlichungstag der Anmeldung: 03.10.2007
(73) Patentinhaber: Schott AG, 55122 Mainz (DE)
(72) Erfinder: MEHRTENS, Andree, 31073 Grünenplan (DE); KÜPPER, Thomas, 37581 Bad Gandersheim (DE); HAMEL, Margareta, 37136 Ebergötzen (DE); MOELLE, Christoph, 55131 Mainz (DE)
(74) Vertreter: Herden, Andreas F.
(86) Internationale Anmeldenummer: PCT/EP2005/013644
(87) Internationale Veröffentlichungsnummer: WO 2006/063855

(56) Entgegenhaltungen:
- EP-A- 0 909 835
- EP-A- 1 348 675
- EP-A- 1 388 593
- WO-A-20/04026785
- WO-A2-20/04067791
- DE-A1- 2 223 670
- DE-A1- 4 422 778
- DE-A1- 10 258 681
- DE-A1- 19 643 039
- US-A- 4 486 487
- US-A- 5 744 227
- US-A- 5 900 285

## Beschreibung

Die Erfindung betrifft ein Verfahren zur Herstellung hochtemperaturstabiler Barriereschichten auf röhrenförmigen, nach dem Beschichten heiß zusammengequetschten Substraten und damit herstellbare Erzeugnisse.

Glassorten sind von sich aus bis zu gewissen Temperaturen, insbesondere bis zum Erweichungspunkt oder der Glasübergangstemperatur beständig. Glas eignet sich daher hervorragend als transparentes, optisch hochwertiges Trennelement, beispielsweise um bestimmte Gasatmosphären vollständig, etwa in Form eines Glasgefäßes einzuschließen, oder sie von anderen Bereichen in Form eines Fensters zu trennen.

In Abhängigkeit von der Gaszusammensetzung können jedoch bei hohen Temperaturen selbst bei Glas unerwünschte Reaktionen chemischer oder physikalischer Natur auftreten, bei welchen die Eigenschaften des Glases nachteilig beeinflußt werden. Beispielsweise kann die Oberfläche des Glases milchig trüb werden, so daß das Glas seine optischen Eigenschaften verändert. Auch kann das Glas zumindest teilweise kristallisieren, was dessen Festigkeit und Dichtigkeit nachteilig beeinflußt. So können Gläser und Glaskeramiken beispielsweise mit Schwefeloxiden, wie sie bei der Verbrennung fossiler Energieträger entstehen, angegriffen werden.

Um diese Effekte zu verhindern oder zu verlangsamen, können Barrierebeschichtungen aufgebracht werden, welche die Oberfläche des Glassubstrats vor der Einwirkung derartiger schädlicher Gasbestandteile schützen. Bekannt ist diesbezüglich unter anderem die Verwendung verschiedener Metalloxide. Derartige Schichten werden üblicherweise mit einem CVD- oder PVD-Verfahren abgeschieden.

Allerdings wachsen diese Schichten unter den in der Produktion üblicherweise verbreiteten Beschichtungsparametern, die im allgemeinen auf hohe Abscheideraten zur Senkung der Produktionskosten optimiert sind, in verschiedenen Wachstumsmoden, wie Säulen- , Insel-oder Lagenwachstum auf. In Abhängigkeit des Wachstumsmodus ergeben sich bestimmte Kristallstrukturen oder Kristallformen der aufwachsenden Schichten, oder die Schichten wachsen amorph, teilkristallin oder feinstkristallin, insbesondere submikrokristallin auf. In Abhängigkeit der Struktur kann es dabei trotz der vorhandenen Barrierebeschichtung zu einer Diffusion zumindest von Gasbestandteilen, beziehungsweise von bestimmten Gassorten durch die Barrierebeschichtung und einer Reaktion mit dem Glassubstrat kommen.

Das Aufbringen einer transparenten Schutzschicht auf eine Glasoberfläche zum Schutz vor unerwünschten chemischen Wechselwirkungen mit Gasatomen aus der unmittelbaren Umgebung ist beispielsweise aus der DE 42 08 376 A1 bekannt. Diese Schutzschicht basiert bevorzugt auf UVtransparenten Fluoriden zum Schutz der Innenwand eines Gasentladungsraumes eines UV-Hochleistungsstrahlers vor Reaktion mit den Gasen eines Füllgases.

Probleme ergeben sich bei den aus dem Stand der Technik bekannten Barriereschichten aber hinsichtlich der Temperaturfestigkeit einerseits und einer erhöhten Diffusion durch ein Säulenwachstum andererseits.

Aus der DE 102 42 848 ist es bekannt, die Morphologie einer Beschichtung mit optischer Funktion und/oder Schutzfunktion hinsichtlich von Temperatureinwirkungen zu stabilisieren, indem dünne Zwischenschichten eingefügt werden. Allerdings kann hier die Morphologie der einzelnen, von dünnen Zwischenschichten unterbrochenen Lagen der Beschichtung, die insbesondere als optisch wirksame und/oder kratzschützende Beschichtung gedacht ist, unter Umständen immer noch die Diffusion von Gasbestandteilen begünstigen. Dies kann beispielsweise der Fall sein, wenn die einzelnen Lagen Säulen- oder Inselwachstum aufweisen.

Der Erfindung liegt daher die Aufgabe zugrunde, Barriereschutzschichten auf einem Substrat anzugeben, bei welcher die Barriereschicht eine möglichst maximale Barriereschutzwirkung für Gase oder speziell für eine bestimmte relevante Gassorte hat, so dass die Gasatome möglichst nur stark zeitverzögert durch die Schutzschicht hindurch zum Substrat gelangen können und damit eine möglichst lang anhaltende Barriereschutzwirkung erzielt wird. Diese Barriereschutzwirkung sollte auch beim Einsatz bei erhöhten Temperaturen möglichst lange anhalten. Diese Aufgabe, eine besonders temperaturbeständige und hoch wirksame Barrierebeschichtung bereitzustellen, wird bereits in höchst überraschend einfacher Weise durch ein beschichtetes Substrat und ein Verfahren zur Herstellung eines beschichteten Substrats gemäß den unabhängigen Ansprüchen gelöst.

Es ist eine weitere Aufgabe, Schichten durch Abscheidung, insbesondere Vakuumabscheidung zu erzeugen, die sich ansonsten mit üblichen Vakuumabscheideverfahren in vergleichbarer Phase nicht oder allenfalls nur äußerst schwierig abscheiden lassen. So können alternativ oder zusätzlich zu einer Barrierewirkung erfindungsgemäß abgeschiedene Schichten auch andere Wirkungen, wie etwa katalytische oder optische Wirkungen haben.

Vorteilhafte Ausgestaltungen und Weiterbildungen sind in den Unteransprüchen angegeben. Der erfindungsgemäße Lösungsansatz liegt insbesondere darin, eine gezielte Beeinflussung des Wachstumsmodus der aufwachsenden Barriereschutzschicht, beispielswiese beim PVD- oder CVD-Prozess so zu erreichen, dass sich eine Kristallstruktur und/oder Morphologie einstellt, die nur eine möglichst geringe Diffusion der relevanten Gassorte durch die Schicht hindurch auf das Substrat hinzu zulässt. Dieses wird in höchst überraschender Weise durch eine Unterteilung der Barriereschutzschicht in eine Vielzahl von sehr dünnen Einzelschichten unterschiedlicher Zusammensetzung und/oder Morphologie erreicht.

Ein Ansatz zur Lösung der dieser Erfindung zugrunde liegenden Aufgabenstellung ist es daher auch, ein Verfahren bereit zu stellen, bei welchem eine Barriereschutzschicht derart hergestellt wird, daß beispielsweise eine für den Anwendungszweck einer Barriereschutzschicht unerwünschte Säulenstruktur oder andere ungünstige Wachstumsformen beim Aufwachsen der Schicht oder der Schichten vermieden werden.

Dieses kann dadurch erreicht werden, dass die aufzubringende mehr oder weniger dicke Barriereschutzschicht so oft in ihrem Wachstum unterbrochen wird, dass gar keine großen Kristallite mehr entstehen können. Jede angefangene dünne aufgebrachte Schicht wird sofort wieder durch eine neu angefangene Schicht anderer Zusammensetzung und/oder Struktur unterbrochen, so dass eine Vielzahl von sehr dünnen Einzelschichten entsteht, wobei jede Schicht durch die nachfolgende in ihrem Kristallwachstum unterbrochen wird. Somit können sich keine großen Kristallite und infolgedessen auch keine Morphologien mit bevorzugten Wachstumsrichtungen wie beispielsweise Säulen bilden.

Der Durchmesser der dabei entstehenden Kristallite liegt dabei bevorzugt in derselben Größe oder Größenordnung wie die Dicke der Einzelschichten und kann somit durch die Dicke der nacheinander aufgebrachten unterschiedlichen oder gleichartigen Einzelschichten gezielt eingestellt werden. Die Größe der entstehenden Kristallite (und damit die Dicke der aufzubringenden Einzelschichten) liegt dabei bevorzugt im submikrokristallinen Bereich und je nach Schichtmaterial bevorzugt unterhalb 50 nm.

Dementsprechend sieht die Erfindung ein beschichtetes Substrat vor, welches eine Barrierebeschichtung mit einer Vielzahl aufeinanderfolgender Einzelschichten umfaßt, welche jeweils eine sich gegenüber einer benachbarten Einzelschicht unterscheidende Beschaffenheit aufweisen, wobei die Einzelschichten eine Schichtdicke von jeweils höchstens 50 Nanometern haben.

Ein derartiges Substrat ist erfindungsgemäß mit einem Verfahren zur Herstellung einer Barrierebeschichtung auf einem Substrat herstellbar, bei welchem zur Herstellung der Barrierebeschichtung eine Vielzahl von aufeinanderfolgenden Einzelschichten abgeschieden wird, die jeweils eine sich gegenüber einer benachbarten Einzelschicht unterscheidende Beschaffenheit aufweisen und deren Schichtdicke jeweils höchstens 50 Nanometer beträgt.

Ebenso kann eine dicke Schicht auch aus einem einzigen Material erzeugt werden, indem sie in Form von vielen dünnen Einzelschichten, erfindungsgemäß also vorzugsweise in Schichten mit höchstens 50 Nanometern Dicke in zeitlich getrennten einzelnen Beschichtungsschritten nacheinander aufgebracht wird. Auf diese Weise werden dicke Schichten mit Morphologien erzeugt, die mit einem einzelnen Beschichtungsschritt nicht erhalten werden können.

Dementsprechend sieht die Erfindung auch ein beschichtetes Substrat vor, welches eine Barrierebeschichtung mit einer Vielzahl aufeinanderfolgender Einzelschichten umfaßt, welche jeweils eine gleichartige Beschaffenheit aufweisen, wobei die Einzelschichten eine Schichtdicke von jeweils höchstens 50 Nanometern haben.

Ein derartiges Substrat ist erfindungsgemäß mit einem Verfahren zur Herstellung einer Barrierebeschichtung auf einem Substrat herstellbar, bei welchem zur Herstellung der Barrierebeschichtung eine Vielzahl von aufeinanderfolgenden Einzelschichten abgeschieden wird, die jeweils gegenüber benachbarten Einzelschichten gleichartige Beschaffenheit aufweisen und deren Schichtdicke jeweils höchstens 50 Nanometer beträgt. Die gleichartigen Schichten können dabei auch unterschiedliche Schichtdicken aufweisen.

Um dabei Morphologien zu erzeugen, die sich in einem einzelnen Beschichtungsvorgang nicht oder nur sehr schwierig realisieren lassen, kann zwischen den Beschichtungsschritten für die Beschichtung der Einzelschichten eine andere Gaszusammensetzung als diejenige, die für den Beschichtungsvorgang verwendet wird, in die Beschichtungsvorrichtung eingeleitet und dann mittels Energieeinkopplung durch eine Plasmabehandlung eine gezielte Beeinflussung der Morphologie der zuvor aufgewachsenen Einzelschicht erreicht werden. Insbesondere hat sich dabei die Einleitung eines ein Reaktivgas enthaltendes oder aus einem solchen Reaktivgas bestehenden Prozessgases als günstig erwiesen. Ein solches Reaktivgas kann insbesondere Sauerstoff sein oder gasförmigen Sauerstoff als Komponente enthalten. Selbstverständlich kann eine solche Plasmabehandlung auch bei der Abscheidung sich voneinander unterscheidender Einzelschichten eingesetzt werden.

Durch das Plasma kann der Sauerstoff ionisiert und in einen hochenergetischen Anregungszustand gebracht werden, wodurch beim Kontakt mit der zuvor aufgebrachten Schicht sehr viel Energie auf diese übertragen werden kann. Die in der dünnen Schicht deponierte Energie kann diese kurzzeitig auf hohe Temperaturen aufheizen und somit Umwandlungen in morphologische Zustände hervorrufen, die durch einen reinen Beschichtungsprozeß mit Abscheidung einer dicken Einzelschicht nicht erreicht werden können.

Für die Erzeugung dickerer Schichten aus unterschiedlichen oder gleichartigen Einzelschichten mit Schichtdicken bis vorzugweise höchstens 50 Nanometer ist es dabei dann zweckmäßig, die Schritte des.Abscheidens einer Einzelschicht und des Plasmabehandelns dieser Einzelschicht mehrmals zu wiederholen.

Bevorzugt wird auch bei der Plasmabehandlung gepulste elektromagnetische Energie verwendet, so wie sie in gleicher oder ähnlicher Weise auch für die plasmaimpulsinduzierte Abscheidung (PICVD) eingesetzt wird. Mit gepulster elektromagnetische Energie -insbesondere gepulste Mikrowellen- oder Hochfrequenzstrahlung- kann während der Pulse sehr viel elektromagnetische Energie bei geringerer mittlerer Energie eingestrahlt werden. Damit kann ohne eine übermäßige Aufheizung des Substrats die Beschichtung mit einem sehr hochenergetischen Plasma behandelt werden. Hier bietet es sich dann auch besonders an, auch die Abscheidung der Schichten mittels PICVD vorzunehmen.

Durch die Plasmabehandlung kann beispielsweise eine unter den gewählten Prozeßparametern aufgewachsene amorphen . Einzelschicht durch das kurzzeitige Erzeugen von hohen Temperaturen in der Oberfläche der Schicht mittels der Plasmabehandlung zum teilweisen oder vollständigen Kristallisieren gebracht werden. Unter anderem kann hier eine Keimbildung für die Kristallisierung oder Teilkristallisierung erfolgen und die Schicht kann sich dann innerhalb kurzer Zeit -während oder auch nach der Plasmabehandlung in eine kristalline oder teilkristalline Schicht umwandeln. Dadurch kann.eine solche in ihrer Morphologie beeinflußte Einzelschicht eine deutlich andere, bevorzugt gezielt höhere Diffusionbarrierewirkung als die zuvor abgeschiedene unbeeinflußte amorphe Einzelschicht aufweisen. Entsprechendes gilt dann auch für die aus oder mit solchen Einzelschichten aufgebaute dickere Schicht.

Durch eine.Abfolge von einander abwechselnden Schritten Beschichtung mit einer amorphen Einzelschicht - Morphologie-Beeinflussung in Form einer Kristallisation mittels der Plasmabehandlung -, usw., kann eine insgesamt kristalline oder teilkristalline dicke Gesamtschicht erzeugt werden; welche durch eine Vielzahl von einzelnen, jeweils zunächst amorph aufgebrachten Schichten mit stets daran anschließender Kristallisation erzeugt wurde.

Umgekehrt kann beispielsweise eine unter den gewählten Prozessparametern aufgewachsene kristalline Schicht durch die Plasmabehandlung und die damit erzeugten kurzzeitigen hohen Temperaturen in der Oberfläche der zuvor aufgewachsenen Einzelschicht zum teilweisen Aufschmelzen gebracht werden. Durch das Abschalten der elektromagnetischen Energie kann dann eine so rasche Abkühlung erfolgen, daß sie dabei ohne zu kristallisieren nahezu vollständig oder zumindest teilweise in einen amorphen Zustand umgewandelt wird. Aufgrund der nicht ausreichenden Zeit für die Keimbildung beim Abkühlen wird die aufgeschmolzene Schicht also in einem glasartigen oder glasigen, beziehungsweise amorphen Zustand eingefroren. Auch eine solche amorphe Schicht kann eine gegenüber einer kristallinen Schicht der gleichen Zusammensetzung deutlich andere, insbesondere auch deutlich höhere Diffusionbarrierewirkung aufweisen. Durch eine Abfolge von einander abwechselnden Schritten Abscheiden einer kristallinen Einzelschicht und Morphologie-Beeinflussung in Form einer Umwandlung in eine zumindest teilamorphe Schicht , usw., kann dann eine insgesamt amorphe, beziehungsweise teilamorphe Schicht erzeugt werden.

Weiterhin ist es auch möglich, Einzelschichten mit einer bestimmten kristallinen Morphologie in eine Einzelschicht mit einer anderen Morphologie mittels der Plasmabehandlung umzuwandeln. So ist es möglich, in Titanoxid-Einzelschichten eine Umwandlung zwischen den Kristallphasen Anatas und Rutil hervorzurufen. Auch können bestimmte Wachstumsstrukturen, wie Säulen-, Insel-oder Lagenwachstum, sowie auch Vorzugsrichtungen in der Kristallorientierung in den Schichten durch die Plasmabehandlung beeinflusst werden. Derartige in unterschiedlichen Wachstumsmoden aufgewachsenen Schichten unterscheiden sich nicht prinzipiell in ihrer Kristallstruktur, also in der relativen Lage und dem Abstand der Atome, sondern nur in der relativen Lage der Kristallachsen und Kristallflächen zur Oberflächenebene und/oder in ihrer relativen Dichte, also ihrem Porositätsgrad. Auch bei einer Umwandlung kristalliner Schichten hinsichtlich ihrer Morphologie ist dabei eine gezielte Beeinflussung der Diffusionbarrierewirkung möglich.

In den vorstehenden Beispielen, also Abscheiden von amorphen Einzelschichten, jeweils mit Schichtdicken von höchstens 50 Nanometern, und jeweils nachfolgender Kristallisation durch Plasmabehandlung, oder Abscheiden von kristallinen Einzelschichten jeweils mit Schichtdicken von höchstens 50 Nanometern und jeweils nachfolgender Umwandlung in zumindest teilamorphe Einzelschichten durch die Plasmabehandlung, sowie der Umwandlung in eine andere kristalline Phase oder Morphologie können jeweils gezielt Morphologien in der Gesamtschicht erzeugt werden, die durch einen einzelnen Abscheidungsschritt mit Abscheidung einer entsprechend dicken Schicht so nicht erreicht werden können.

Auch im Falle, daß Schichten mit gleichartiger Beschaffenheit abgeschieden werden, wird davon ausgegangen, daß die Einzelschichten im allgemeinen auch in der aus diesen Schichten aufgebaute dickere Schicht aufgrund der Unterbrechung des Beschichtungsvorgangs und des erneuten Abscheidens einer Einzelschicht unterscheidbar bleiben. Insbesondere auch bei einer nachfolgenden Plasmabehandlung ist davon auszugehen, daß sich die Plasmabehandlung auf die Oberfläche einer Einzelschicht anders auswirkt, als auf Bereiche nahe der Grenzfläche zur darunterliegenden, davor abgeschiedenen Schicht. Die damit einhergehenden Morphologieunterschiede bleiben auch nach Abschluß der Herstellung der Schicht, beispielsweise bei einer elektronenmikroskopischen Analyse der Schicht an der Bruchkante im allgemeinen feststellbar.

Eine erfindungsgemäße Schicht, die in vielen Einzelschritten als Abfolge dünner gleichartiger oder unterschiedlicher Einzelschichten abgeschieden wird, kann weiterhin zusätzlich oder alternativ zu einer Barrierewirkung auch andere Eigenschaften aufweisen. Gedacht ist hier unter anderem auch an eine katalytisch wirksame, insbesondere auch photokatalytisch wirksame und/oder hydrophile Schicht. So kann eine erfindungsgemäße Beschichtung Titanoxid-haltige, photokatalytisch wirksame Einzelschichten aufweisen. Wird die Beschichtung aus derartigen gleichartigen Schichten aufgebaut, so können durch die erfindungsgemäße Abscheidung in vielen feinlaminaren Schichten Phasen und Morphologien der Schicht stabilisiert werden, die besonders katalytisch wirksam sind. Mittels der Erfindung können dann beispielsweise Titanoxid-Schichten in Form von Schichtstapeln mit abwechselnden dünnen Anatas- und Rutil-Schichten hergestellt werden. Um die gewünschte Kristallphase zu erzeugen kann dabei eine Plasmabehandlung eingesetzt werden. Auch können mehrere aufeinanderfolgende gleichartige photokatalytisch wirksame dünne Einzelschichten aufeinander abgeschieden werden. Optional kann hier zur Herstellung der gewünschten Morphologie und/oder Phase der Schichten eine Plasmabehandlung zwischengeschaltet werden.

Ein erfindungsgemäß hergestellter Katalysator mit einem Substrat und einer Vielzahl von dünnen Einzelschichten der oben genannten Schichtdicken kann unter anderem als Luftfilter, etwa im Automobilbereich zur Luft- und/oder Abgasfilterung in Kraftfahrzeugen eingesetzt werden.

Im Gegensatz zu bekannten Barriereschutzschichten wird erfindungsgemäß nicht eine Funktionsschicht durch eine oder einige wenige dünne Zwischenschichten unterteilt, sondern die Funktionsschicht, also die gesamte Barriereschutzschicht, wird aus einer Vielzahl von sehr dünnen Einzelschichten aufgebaut. Durch diesen erfindungsgemäßen feinlaminaren Schichtaufbau wird nicht nur eine nachträgliche Umwandlung der Morphologie bei Temperatureinfluss verhindert, sondern es wird überdies von vorn herein bei der Herstellung gezielt eine Schichtmorphologie erzeugt, die von sich aus eine möglichst geringe Diffusionswirkung für bestimmte Gassorten durch die Schicht hindurch aufweist und diese Barriereschutzwirkung auch zu hohen Temperaturen hin beibehält. Die erhöhte Temperaturbeständigkeit einer erfindungsgemäßen Barrierebeschichtung beruht auf der überraschenden Erkenntnis, daß derartig dünne Schichten nicht oder kaum noch zu Phasenumwandlungen oder anderweitigen Änderungen der Morphologie neigen.

Die Barrierewirkung der erfindungsgemäßen Beschichtung kann durch noch geringere Schichtdicken der Einzelschichten noch weiter verbessert werden. So ist gemäß einer bevorzugten Ausführungsform der Erfindung ein beschichtetes Substrat vorgesehen, bei welchem zumindest eine der Einzelschichten, bevorzugt mehrere Einzelschichten, insbesondere mehrere aufeinanderfolgende Einzelschichten, insbesondere auch alle Einzelschichten der Barrierebeschichtung eine Schichtdicke von höchstens 10 Nanometern aufweisen, beziehungsweise mit diesen Schichtdicken abgeschieden werden. Gemäß noch einer Weiterbildung der Erfindung ist ein beschichtetes Substrat vorgesehen, bei welchem zumindest eine der Einzelschichten, bevorzugt mehrere Einzelschichten, insbesondere mehrere aufeinanderfolgende Einzelschichten, insbesondere auch alle Einzelschichten der Barrierebeschichtung eine Schichtdicke von höchstens 2 Nanometern, bevorzugt auch kleiner 2 Nanometern aufweisen, beziehungsweise mit derartigen Schichtdicken abgeschieden werden. Bei so geringen Einzelschichtdicken kleiner 10 Nanometer oder sogar kleiner 2 Nanometer sind die entstehenden Kristallite schon in der Größenordnung der Elementarzelle, so daß sich somit typische Korngrenzen in einer bestimmten Richtung gar nicht erst ausbilden können.

Besonders geeignet zur Herstellung der erfindungsgemäß sehr dünnen Einzelschichten sind verschiedene Vakuumabscheideverfahren. Es können beispielsweise auch mehrere Vakuumabscheideverfahren kombiniert werden. Unter einem Vakuumabscheideverfahren wird ein Verfahren verstanden, bei welchem eine Beschichtung in einer zumindest teilevakuierten Umgebung vorgenommen wird. Bevorzugt wird die Herstellung zumindest eines Teils der Einzelschichten mittels Vakuumabscheideverfahren wie plasmaimpuls-unterstützter Dampfphasenabscheidung und oder Aufsputtern. Beispielsweise erlaubt die plasmaimpulsunterstützte Dampfphasenabscheidung (PICVD) eine gute Kontrolle der Schichtdicke durch Abzählen der Plasmapulse, da die Anzahl der Plasmapulse im wesentlichen proportional zur abgeschiedenen Schichtdicke ist. Auch mittels Sputtern lassen sich gut reproduzierbar sehr dünne Schichten, wie sie erfindungsgemäß benötigt werden, herstellen.

Im aufgebrachten Schichtpaket der erfindungsgemäßen Barrierebeschichtung kann sich eine Einzelschicht der Barrierebeschichtung von einer benachbarten Einzelschicht durch ihre chemische Zusammensetzung und/oder durch ihre Morphologie unterscheiden. Eine Möglichkeit einer sich von einer benachbarten Schicht unterscheidenden Morphologie ist eine sich unterscheidende Kristallstruktur. Dabei können eine oder mehrere der Einzelschichten kristalline, insbesondere feinstkristalline oder teilkristalline Struktur aufweisen.

Noch eine Möglichkeit ist, daß die Einzelschichten sich durch ihren Wachstumsmodus unterscheiden. Beispielsweise können Schichten mit beginnendem Säulenwachstum und Lagenwachstum aufeinandergestapelt werden.

Die Barrierebeschichtung zumindest eines Teilschichtpakets kann so auch Einzelschichten gleicher Zusammensetzung, aber unterschiedlicher Morphologie umfassen, um eine gegenüber einer dicken Einzelschicht wesentlich verbesserte Barrierewirkung und Temperaturbeständigkeit zu erreichen.

Um derartige Schichtpakete herzustellen, können gemäß einer Ausführungsform des erfindungsgemäßen Verfahrens aufeinanderfolgend Einzelschichten unterschiedlicher Morphologie vorteilhaft durch Wechsel der Prozeßparameter von einer Schicht zu einer nachfolgenden Schicht abgeschieden werden. Mögliche Beispiele der Variation der Prozeßparameter sind unter anderem:
- unterschiedlicher Partialdruck des Precursorgases bei PICVD-Beschichtung,
- unterschiedliche Temperatur durch unterschiedliche Mikrowellenleistung beim PICVD-Verfahren,
- Änderung der Pulsenergie und/oder Pulsdauer und/oder des Taktverhältnisses der Mikrowellenpulse bei PICVD-Beschichtung,
- eine Veränderung der Abscheiderate,
- die Änderung der Gasdichte bei Kathodenzerstäubung.

Gemäß noch einer Weiterbildung der Erfindung ist vorgesehen, daß zumindest eine der Einzelschichten amorphe Struktur aufweist. Sollte eine unter den eingestellten Prozessparametern entstehende Einzelschicht von sich aus amorph aufwachsen, können sich zwar auch keine Kristallstrukturen wie Säulen ausbilden, allerdings ist die Diffusionswirkung von amorphen Schichten oft nicht so gut wie die von kristallinen Schichten geeigneter Morphologie, da amorphe Strukturen oft wegen ihrer geringeren Packungsdichte von sich aus nicht so dicht sind wie die von kristallinen Strukturen und daher auf Grund ihrer erhöhten Porosität auch nicht so hohe Diffusionssperrwirkung gegenüber Gasatome haben. Ein besonderer Vorzug einer amorphen Einzelschicht ist aber, daß sie eine besonders gute Unterbrechung des Wachstumsmodus benachbarter Einzelschichten bewirkt. Amorphe Schichten sind daher besonders gut in Verbindung mit anderen benachbarten kristallinen oder teilkristallinen Schichten geeignet.

Dementsprechend sieht eine vorteilhafte Ausführungsform der Erfindung ein beschichtetes Substrat vor, bei welchem die Barrierebeschichtung zumindest ein Teilschichtpaket mit amorphen und benachbarten, zumindest teilkristallinen, bevorzugt feinstkristallinen Schichten umfaßt. Dazu kann als Weiterbildung auch zumindest ein Teilschichtpaket der Barrierebeschichtung mit zwei zumindest teilkristallinen, bevorzugt feinstkristalllinen Schichten unterschiedlicher Zusammensetzung, zwischen denen jeweils eine amorphe Schicht angeordnet ist, abgeschieden werden.

Eine vorteilhafte Weiterbildung der Erfindung sieht weiterhin vor, daß die Barrierebeschichtung zumindest ein Teilschichtpaket mit abwechselnden Schichten unterschiedlicher Beschaffenheit umfaßt. Derartige als Wechselschichten ausgebildete Schichtpakete sind besonders leicht durch abwechselndes Abscheiden zweier Schichtarten herstellbar.

Besonders bevorzugt ist die Barrierebeschichtung transparent. Diese kann dann insbesondere in Verbindung mit transparenten Substraten eingesetzt werden. Um eine optisch unauffällige Barrierebeschichtung zu erreichen, kann die Transparenz der Barrierebeschichtung vorteilhaft auch der Transparenz des Substrats entsprechen. Es ist dabei gelungen, Barrierebeschichtungen bereitzustellen, bei welchen die Lichttransmission durch ein mit der Barrierebeschichtung beschichtetes Substrat von der Transmission eines Substrats ohne die Barrierebeschichtung im sichtbaren Spektralbereich um höchstens 5% abweicht.

Eine optische Unauffälligkeit der Barrierebeschichtung kann insbesondere auch erreicht werden, indem der Brechungsindex der Barrierebeschichtung dem Brechungsindex der Substratoberfläche entspricht oder von diesem um höchstens 5 % abweicht. Als Brechungsindex der Barrierebeschichtung ist dabei ein effektiver Brechungsindex zu verstehen. Der effektive Brechungsindex ergibt sich dabei aus dem Zusammenwirken der Einzelschichten. Im allgemeinen kann der effektive Brechungsindex beispielsweise als mit der Schichtdicke der Einzelschichten gewichteter Mittelwert der Brechungsindizes der Einzelschichten angesetzt werden.

Gemäß einer anderen Weiterbildung der Erfindung kann die Dicke zumindest eines Teilschichtpakets und dessen effektiver Brechungsindex so bemessen sein, daß die Barrierebeschichtung entspiegelnd wirkt. Dazu kann insbesondere ein Entspiegelungsschichtsystem mit der . Barrierebeschichtung vorgesehen sein, wobei das Gesamtschichtsystem des Entspiegelungsschichtsystem entspiegelnd wirkt und zumindest eine Schicht des Entspiegelungsschichtsystems ein Teilschichtpaket mit einer Vielzahl dünner aufeinanderfolgender Schichten mit einer durchschnittlichen Dicke von höchstens 50 Nanometern umfaßt oder durch ein solches Teilschichtsystem mit einer Vielzahl aufeinanderfolgender Einzelschichten von durchschnittlich höchstens 50 Nanometer, bevorzugt durchschnittlich 10 Nanometern Dicke ersetzt ist, wobei dessen effektiver Brechungsindex so bemessen ist, daß das Gesamtschichtsystem mit der Barrierebeschichtung insgesamt entspiegelnd wirkt.

Um die Anforderungen der Barrierebeschichtung an Temperaturbeständigkeit und Barrierewirkung zu erfüllen, enthält besonders bevorzugt zumindest eine der Einzelschichten, bevorzugt alle Einzelschichten zumindest ein anorganisches Oxid. Insbesondere ist bevorzugt vorgesehen, anorganische Oxidschichten abzuscheiden. Geeignete Oxide sind insbesondere TiO₂, ZrO₂, SiO₂, Al₂O₃, Nb₂O₅, Ta₂O₅, HfO₂. Selbstverständlich können diese Oxide auch als Mischoxid-Einzelschichten miteinander kombiniert abgeschieden werden.

Die erhöhte Temperaturbeständigkeit der erfindungsgemäßen Barrierebeschichtung basiert, wie bereits oben ausgeführt wurde, auf dem Effekt, daß derartig dünne Schichten einer erfindungsgemäßen Barrierebeschichtung aus entsprechend kleinen Kristalliten auch unter dauernder Temperaturbelastung kaum noch zu Änderungen der Morphologie neigen und daher gegenüber dickeren Schichten deutlich stabiler sind. Durch die geringe Größe der Kristallite wird auch eine besonders gute Barrierewirkung erreicht, da große Grenzflächen an den Kristalliten, die in Richtung auf das Substrat verlaufen, vermieden werden.

Hinsichtlich der Auswahl der Substratmaterialien gibt es kaum Einschränkungen. Die Vorteile der Erfindung ergeben sich aber insbesondere in Verbindung mit temperaturbeständigen Materialien, wie Glas, Glaskeramik, Keramik, Metall, verschiedene Halbleiter oder kristalline Werkstoffe.

Die Substrate sind hohl, und röhrenförmig. Dabei kann mittels der Erfindung auch eine Innenbeschichtung solcher Substrate durchgeführt werden.

Ein hohles Substrat kann ein Lampenkolben oder auch ein Rohr sein, aus welchem dann ein oder mehrere Lampenkolben oder auch andere Gefäße durch Erhitzen und Zusammenquetschen des Rohrs hergestellt werden. Die feinlaminare Schicht ist hinreichend thermisch so stabil, daß sie beim Aufheizen für das Zusammenquetschen des Rohrs nicht zerstört wird. Damit wird dementsprechend ein beschichtetes Substrat in Form eines nach dem Beschichten unter Bildung eines abgeschlossenen Hohlraums heiß zusammengequetschten Rohres erhalten.

Allgemein werden zur Herstellung erfindungsgemäßer Erzeugnisse mit beschichteten Substraten mehrere sehr dünne Schichten abgeschieden. Wird eine CVD-Beschichtung und/oder eine nach der Beschichtung einer Einzelschicht durchgeführte Plasmabehandlung vorgenommen, so ergibt sich dabei das Problem, daß die verwendeten Gasgemische für Abscheidung und/oder Plasmabehandlung sehr schnell zu wechseln sein sollten, um eine im Vergleich zu einer Abscheidung einer entsprechend dicken Einzelschicht noch annehmbare Geschwindigkeit für die Beschichtung zu erreichen. Dieses Problem verschärft sich insbesondere auch dann, wenn die Substrate und/oder der Reaktor der Beschichtungsvorrichtung klein sind und die Durchströmung des Gases dadurch behindert oder verlangsamt wird. Um einen schnellen Wechsel der Gasbestandteile in einem Reaktor für die CVD-Beschichtung zu ermöglichten, kann eine Vorrichtung zur CVD-Beschichtung von Substraten, insbesondere mit erfindungsgemäßen Schichtsystemen, beziehungsweise zur Durchführung des erfindungsgemäßen Verfahrens verwendet werden, bei welcher mehrere Gasreservoirs mittels ansteuerbarer Ventile an einer mit einer Pumpe verbundenen Hauptleitung angeschlossen sind. Der Reaktor ist nun über eine von dieser Hauptleitung abzweigenden Zweigleitung an die Gasversorgung mit den mehreren Gasreservoirs angeschlossen und mit einer Pumpe, im einfachsten Fall mit derselben Pumpe, welche auch die Hauptleitung evakuiert, verbunden, um den Reaktor zu evakuieren und das Prozeßgas auszutauschen. Dabei weist die Hauptleitung gegenüber der Zweigleitung mit Reaktor und darin aufgenommenem Substrat einen niedrigeren Strömungswiderstand, beziehungsweise eine höhere Gasfluß- oder Gasaustauschgeschwindigkeit auf. Dementsprechend basiert das erfindungsgemäße Verfahren zur plasmaunterstützten CVD-Beschichtung von Substraten gemäß dieser Ausführungsform der Erfindung darauf, daß das Substrat in einem Reaktor angeordnet wird, wobei das Gas für die Plasmabeschichtung oder Plasmabehandlung dem Reaktorraum über eine Zweigleitung zugeführt wird, welche an eine Hauptleitung angeschlossen ist, durch welche mittels eines Gasversorgungssystems das Gas oder Gasgemisch für die CVD-Beschichtung bereitgestellt wird und welche gegenüber der Zweigleitung mit Reaktor und darin aufgenommenem Substrat einen niedrigeren Strömungswiderstand aufweist, und wobei mittels Einstrahlung elektromagnetischer Energie im Prozeßgas im Reaktor ein Plasma für die Beschichtung oder Plasmabehandlung erzeugt wird, und wobei Haupt- und Zweigleitung über zumindest eine Pumpe abgepumpt werden.

Um eine Plasmabeschichtung, sowie eventuell auch eine Plasmabehandlung zur Änderung der Schichtmorphologien durchzuführen, ist weiterhin noch eine Einrichtung zur Einstrahlung elektromagnetischer Energie in den Reaktorraum vorgesehen. Vorzugsweise wird dazu, wie oben bereits beschrieben, gepulste elektromagnetische Energie zur PICVD-Beschichtung, beziehungsweise zur Behandlung der abgeschiedenen Schichten in einem gepulsten Plasma mittels einer entsprechenden Einrichtung eingesetzt.

Ein erhöhter Strömungswiderstand ist insbesondere oft dann gegeben, wenn der Reaktor zur Innenbeschichtung hohler Substrate ausgebildet ist. In diesem Fall werden besonders bei Substraten mit kleinen Innendurchmessern die Strömungswiderstände vornehmlich durch die Abmessungen der Substrate bestimmt.

Durch die Anordnung mit Hauptleitung und Zweigleitung kann an der Zweigleitung trotz deren höherem Strömungswiderstand aufgrund des schnellen Gasaustauschs an der Hauptleitung auch im Reaktor das Gas oder Gasgemisch für die Plasmabeschichtung oder Plasmabehandlung bereitgestellt werden. In diesem Sinne kann die Hauptleitung auch als Bypass zur Erniedrigung des Gesamt-Strömungswiderstands aufgefasst werden.

Vorzugsweise wird auch die Gasmenge über eine Druck-und/oder Mengenregelungseinrichtung an der Hauptleitung vorgenommen. Dazu kann eine Druckregelung mittels einer Druckmeßeinrichtung und ein in der Hauptleitung angeschlossenes Regelventil, mit welchem in Abhängigkeit von den mit der Druckmeßeinrichtung aufgenommenen Druckmeßwerten der Druck in der Hauptleitung auf einen Sollwert eingeregelt wird. Um den Gesamt-Strömungswiderstand so gering wie möglich zu halten, ist es dabei von Vorteil, wenn das Regelventil in Strömungsrichtung hinter dem Abzweig der Zweigleitung angeordnet ist.

Im folgenden wird die Erfindung anhand von Ausführungsbeispielen und unter Bezugnahme auf die Zeichnungen näher erläutert, wobei gleiche und ähnliche Elemente mit gleichen Bezugszeichen versehen sind und die Merkmale verschiedener Ausführungsbeispiele miteinander kombiniert werden können.

Es zeigen:
Fig. 1A bis 1C verschiedene Wachstumsmodi von Beschichtungen, wobei Fig. 1C eine erfindungsgemäße Beschichtung zeigt,
Fig. 2 ein Ausführungsbeispiel eines erfindungsgemäß beschichteten Substrats mit einem Wechselschichtsystem als Barrierebeschichtung,
Fig. 3 eine Ausführungsform der Erfindung mit amorphen Einzelschichten,
Fig. 4 eine Abwandlung des in Fig. 3 dargestellten Beispiels,
Fig. 5A bis 5D berechnete Spektralkurven der Transmission verschiedener erfindungsgemäßer Barrierebeschichtungen,
Fig. 6 ein Ausführungsbeispiel einer Vorrichtung zur Durchführung der Beschichtung und Plasmabehandlung, und
Fig. 7 ein Ausführungsbeispiel eines erfindungsgemäß beschichteten Lampenkolbens.

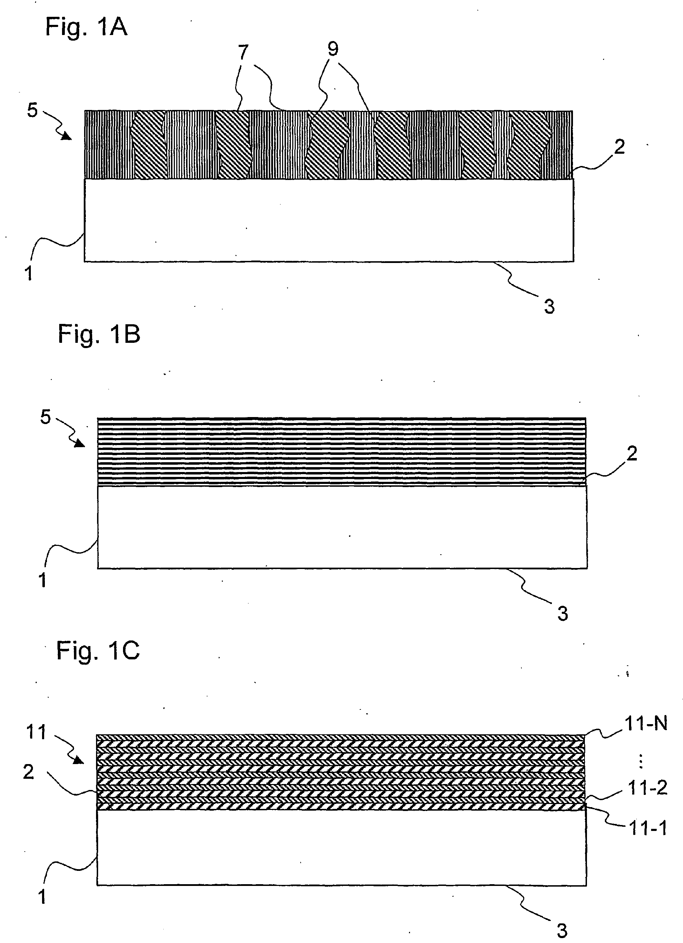

In den Fig. 1A bis 1C sind verschiedene Barrierebeschichtungen dargestellt, wobei Fig. 1C eine Ausführungsform einer erfindungsgemäßen feinlaminaren Barrierebeschichtung zeigt. Fig. 1A zeigt eine Einzelschicht als Barrierebeschichtung 5 auf einer Seite 2 eines Substrats 1. Diese Einzelschicht zeigt, wie dies häufig in der Praxis zu beobachten ist, Säulenwachstum. Dabei bilden sich auf der beschichteten Fläche 2 des Substrats 1 säulenförmige Kristallite 7 mit Korngrenzen 9, welche sich von der Substratfläche 2 ausgehend in Richtung zur Oberfläche der Barrierebeschichtung 5 erstrecken. Diese gerade in Richtung auf das Substrat hin orientierten Korngrenzen bei Säulenwachstum sind aber für eine angestrebte hohe Diffusionsbarrierewirkung von Gasatomen äußerst ungünstig, da sich die Gasatome bevorzugt entlang dieser Korngrenzen bewegen.

Fig. 1B zeigt den Idealfall einer Barrierebeschichtung 5 mit einer Einzelschicht. Bei dieser Barrierebeschichtung liegt Lagenwachstum vor, wobei die Kristallränder oder Korngrenzen bevorzugt parallel zur Substratoberfläche verlaufen, so dass diffundierende Gasatome keine bevorzugten Diffusionskanäle in Richtung auf das Substrat hin, sondern nur senkrecht dazu haben. Dieser Fall des Lagenwachstums ist in der Praxis allerdings kaum zu erreichen. Um ein sauberes Lagenwachstum zu erhalten, sind unter anderem im allgemeinen sehr kleine Abscheideraten erforderlich, so daß eine wie in Fig. 1B dargestellte Beschichtung bereits aus wirtschaftlichen Gesichtspunkten uninteressant ist.

Fig. 1C zeigt eine erfindungsgemäße Barrierebeschichtung 11 auf dem Substrat 1, mit welcher ein wie in Fig. 1B dargestelltes Lagenwachstum in seinen Eigenschaften angenähert werden kann. Die näherungsweise Realisierung des angestrebten Lagenwachstums wird erfindungsgemäß durch das Beschichten mit einem feinlaminaren Vielfachschichtsystem mit dünnen Einzelschichten 11-1, 11-2, ..., 11-N erreicht. Dabei werden durch die entstehenden Grenzflächen bevorzugt Grenzflächen gebildet, die parallel zur Substratoberfläche 2 verlaufen und somit für eine Diffusion von Gasatomen durch die Beschichtung hindurch in Richtung auf das Substrat gerade sehr ungünstig sind.

Jede Einzelschicht der Vielzahl aufeinanderfolgender Einzelschichten 11-1, 11-2, ..., 11-N, der Barrierebeschichtung 11 weist darüber hinaus jeweils eine sich gegenüber einer benachbarten Einzelschicht unterscheidende Beschaffenheit auf, wobei die Einzelschichten eine Schichtdicke von jeweils höchstens 50 Nanometern haben. Bevorzugt ist die Schichtdicke zumindest eines Teils der Einzelschichten 11-1, 11-2, ..., 11-N kleiner als 10 Nanometern. Insbesondere können einige oder alle Einzelschichten 11-1, 11-2, ..., 11-N sogar höchstens 2 Nanometern, bevorzugt auch kleiner 2 Nanometern aufweisen.

Gemäß einer weiteren Ausführungsform der.Erfindung sind die Einzelschichten 11-1, 11-2, ..., 11-N oder zumindest ein Teilschichtpaket dieser Einzelschichten gleichartig beschaffen. Dabei bezieht sich die gleichartige Beschaffenheit auf die Zusammensetzung und Morphologie der Schichten, nicht zwangsläufig auch auf deren Dicke.

Die Einzelschichten 11-1, 11-2, ..., 11-N werden gemäß einer Ausführungsform der Erfindung durch Abscheidung, vorzugsweise mittels PICVD und eine nachfolgende Plasmabehandlung zur Änderung der Morphologie der dünnen, jeweils zuletzt aufgebrachten Einzelschicht durchgeführt. Wird mit der Plasmabehandlung, insbesondere in einem Reaktivgas-Plasma, wie etwa einem Sauerstoff-Plasma eine gezielte Kristallisation erreicht, so führt auch hier die jeweils sukzessive Abscheidung und Kristallisation dazu, daß die Kristallite nicht, oder nicht ohne weiteres eine Größe in Richtung senkrecht zur Oberfläche annehmen können, welche die Schichtdicke der dünnen Einzelschichten übersteigt. Umgekehrt können auf diese Weise auch amorphe oder teilamorphe dicke Schichten erzeugt werden, wenn die Plasmabehandlung zu einem oberflächlichen Aufschmelzen und das Abschalten der elektromagnetischen Energie zum Einfrieren des geschmolzenen Zustands führt.

Auch bleiben die Einzelschichten selbst bei Herstellung einer Abfolge von Einzelschichten gleichartiger Beschaffenheit im allgemeinen unterscheidbar. So bleibt im allgemeinen bei kristallinen oder teilkristallinen Schichten die Grenzfläche zwischen aufeinanderfolgenden Einzelschichten aufgrund des an der Grenzfläche unterbrochenen, beziehungsweise dort wieder beginnenden Kristallwachstums erkennbar. Um diese Struktur sichtbar zu machen, könnte zum Beispiel eine elektronenmikroskopischen Untersuchung an einer Kante durchgeführt werden.

Auch bei Einzelschichten mit jeweils unterschiedlicher Beschaffenheit kann selbstverständlich eine Plasmabehandlung einer oder aller Schichtarten zur Beeinflussung von Morphologie und/oder Zusammensetzung durchgeführt werden. Beispielsweise kann eine solche Plasmabehandlung eingesetzt werden, um bei einem Schichtstapel mit Titanoxid-Schichten eine bestimmte erwünschte Kristallphase und/oder Wachstumsstruktur zu erzeugen. Titanoxid-haltige Schichten, insbesondere mit aufeinanderfolgenden Titanoxid-Einzelschichten oder auch im Kombination mit benachbarten unterschiedlichen Schichten können auch als photokatalytisch wirksame Schichten eingesetzt werden. Dabei ist eine Barrierewirkung nicht zwingend erforderlich. Ein derartig beschichtetes Substrat kann beispielsweise als Katalysator dienen. Eine mögliche Anwendung liegt dabei in der katalytischen, vorzugsweise photokatalytischen Neutralisierung von Ozon oder anderen Schadstoffen. Um einen Filter oder Katalysator herzustellen, kann dabei auch ein hohles Substrat, insbesondere mit einer Vielzahl von Hohlräumen oder Kanälen, beispielsweise mit wabenförmigem Querschnitt, mit einer erfindungsgemäßen feinlaminaren Beschichtung versehen werden. Auch ein Fasermaterial, beispielsweise in Form eines Vlieses oder Gewebes kann zur Vergrößerung der katalytisch wirksamen Oberfläche als Substrat verwendet werden. Dazu eignen sich insbesondere temperaturstabile Glasfaser- oder Mineralfaser-Vliese, beziehungsweise - Gewebe.

Zur Herstellung einer wie in Fig. 1C dargestellten Barrierebeschichtung mit einer Vielzahl von aufeinanderfolgend abgeschiedenen Einzelschichten 11-1, 11-2, ..., 11-N, die jeweils eine sich gegenüber einer benachbarten Einzelschicht unterscheidende oder auch gleichartige Beschaffenheit aufweisen und deren Schichtdicke jeweils höchstens 50 Nanometer beträgt, können bevorzugt Vakuumabscheideverfahren, wie Sputtern oder PICVD eingesetzt werden. Es können dabei auch verschiedene Verfahren miteinander kombiniert werden. Besonders bevorzugt werden als Einzelschichten 11-1, 11-2, ..., 11-N anorganische Oxidschichten abgeschieden. Geeignete Schichtmaterialien sind dabei unter anderem TiO₂, ZrO₂, Si02, Al₂O₃, Nb₂O₅, Ta₂O₅, HfO₂. Eine oder mehrere der Einzelschichten können dabei beispielsweise auch Mischoxide enthalten. Vorzugsweise wird die Barrierebeschichtung, insbesondere in Verbindung mit Glas, Glaskeramik oder einem kristallinen Werkstoff, wie etwa Kalziumfluorid als Substratmaterial transparent abgeschieden. Selbstverständlich ist die Erfindung aber auch für andere Substratmaterialien, insbesondere für temperaturbeständige Materialien, wie Keramik, Metalle oder Halbleiter geeignet.

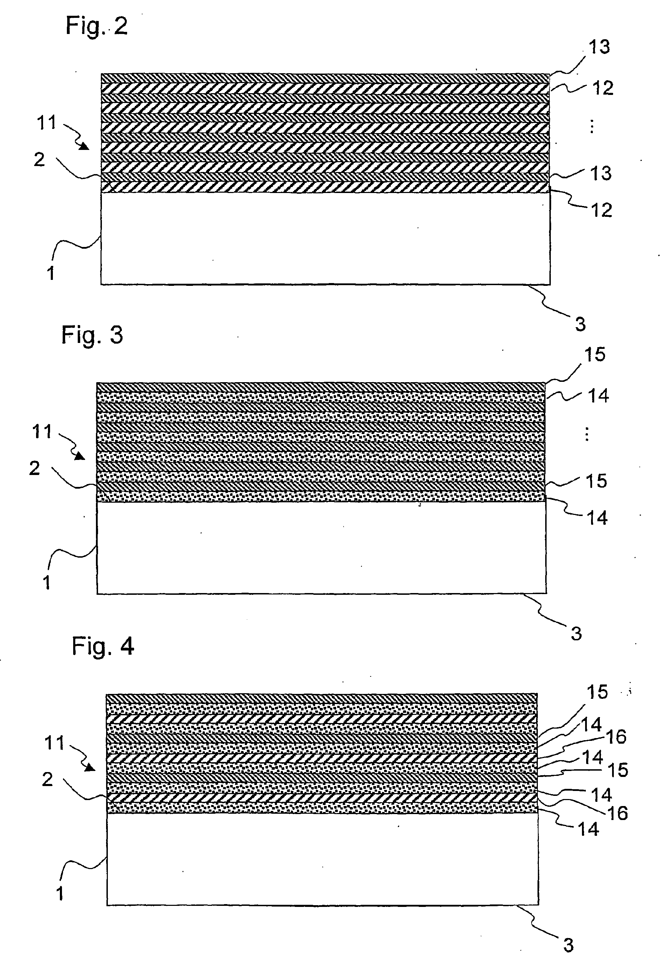

Fig. 2 zeigt ein Ausführungsbeispiel eines beschichteten Substrats mit einer Barrierebeschichtung 11 mit einem feinlaminaren Vielfachschichtsystem welches abwechselnde Schichten 12, 13 unterschiedlicher Beschaffenheit umfaßt. Die Schichten 12, 13 weisen bei diesem Ausführungsbeispiel jeweils zumindest teilkristalline, insbesondere kristalline, besonders bevorzugt feinstkristalline Struktur auf.

Die Schichten 12 können sich dabei beispielsweise von den zu ihnen jeweils benachbarten Schichten 13 durch ihre chemische Zusammensetzung unterscheiden. Wird PICVD oder ein anderes chemisches Dampfabscheideverfahren eingesetzt, kann zur Herstellung der Schichten in diesem Fall beispielsweise während der Beschichtung die Prozeßgaszusammensetzung geändert werden, so daß jeweils unterschiedliche Metalloxide abgeschieden werden.

Ebenso können die jeweils gleichartigen Schichten 12 von den zu diesen benachbarten, ebenfalls jeweils gleichartigen Schichten 13 in ihrer Morphologie verschieden sein. So ist gemäß einer Ausführungsform der Erfindung vorgesehen, daß die Schichten 11, 12 gleichartige chemische Zusammensetzung aufweisen, sich aber -bedingt etwa durch eine Veränderung der Prozeßparameter beim Abscheiden in ihrer Kristallstruktur unterscheiden. Auch können die Schichten jeweils zu den benachbarten Schichten hinsichtlich ihres Wachstumsmodus verschieden sein. So können beispielsweise die Schichten 12 in beginnendem Säulenwachstum und die Schichten 13 im Lagenwachstum aufwachsen.

Fig. 3 zeigt ein Ausführungsbeispiel eines erfindungsgemäß beschichteten Substrats 1, bei welchem die Barrierebeschichtung 11 Einzelschichten 14 mit amorpher Struktur umfaßt. Insbesondere umfaßt die Barrierebeschichtung hier amorphe Einzelschichten 14 und benachbarte, zumindest teilkristalline, bevorzugt feinstkristallinen Einzelschichten 15. Dementsprechend ist auch bei diesem Beispiel die Barrierebeschichtung als Wechselschichtsystem mit abwechselnden Schichten 14, 15 aufgebaut, wobei die Schichten 14 ebenso wie die Schichten 15 jeweils gleichartig sind.

Auch bei dieser Ausführungsform der Erfindung können sich die amorphen Schichten 14 von den jeweils benachbarten Schichten 15 durch ihre chemische Zusammensetzung unterscheiden. Ebenso können die Schichten 14 und 15 aber auch chemisch gleichartig sein und sich durch ihre Morphologie -amorph und kristallin- unterscheiden. So können die Schichten 14 beispielsweise aus amorphem Siliziumoxid und die Schichten 15 aus kristallisiertem Siliziumoxid aufgebaut sein. Die amorph abgeschiedenen Schichten 14 können dann wirkungsvoll verhindern, daß sich in der Beschichtung 11 größere Kristallite bilden.

In Fig. 4 ist eine Variante des in Fig. 3 dargestellten Beispiels dargestellt. Auch bei dem in Fig. 4 dargestellten Beispiel umfaßt die Barrierebeschichtung 11 amorphe Einzelschichten.14. Bei dem in Fig. 4 gezeigten Beispiel ist die Barrierebeschichtung jedoch nicht als Wechselschichtsystem mit zwei alternierenden Schichtarten, wie Fig. 2 oder Fig. 3 aufgebaut.
Vielmehr ist die Barrierebeschichtung 11 aus einem Schichtstapel mit zwei zumindest teilkristallinen, bevorzugt feinstkristalllinen Schichten 15, 16 unterschiedlicher Zusammensetzung aufgebaut, zwischen denen jeweils eine amorphe Schicht angeordnet ist. Der feinlaminare Aufbau des Vielfachschichtpaketes der Barrierebeschichtung 11 mit zwei feinstkristallinen Schichten 15, 16 unterschiedlicher chemischer Zusammensetzung, die jeweils durch eine amorphe Schicht voneinander getrennt sind, ist vorteilhaft, um unerwünschte Wechselwirkungen zwischen den beiden kristallinen Strukturen der Schichten 15, 16, z.B. die Bildung von Mischkristallen, zu unterbinden. Die amorphe Zwischenschicht 14 kann dabei der Zusammensetzung einer der beiden kristallinen Schichten entsprechen oder auch eine andere Zusammensetzung haben.

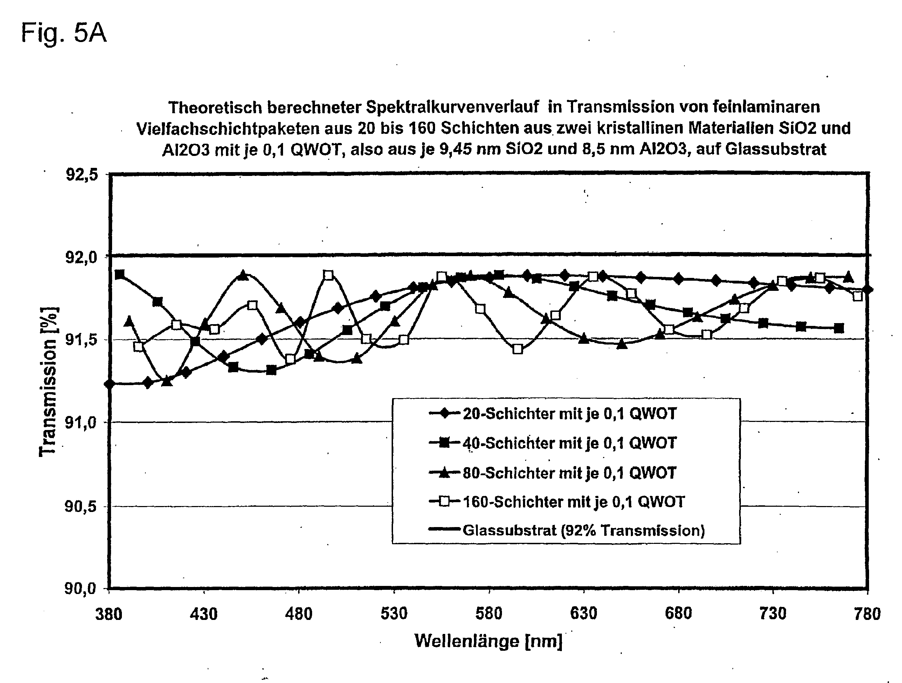

Die Fig. 5A bis 5C zeigen errechnete spektrale Verläufe der Transmission durch erfindungsgemäß beschichtete Substrate. Zusätzlich eingezeichnet ist die Transmission eines unbeschichteten Glassubstrates, die vereinfacht als über den dargestellten Wellenlängenbereich konstant angenommen wurde. Die in den Fig. 5A bis 5C dargestellten Beispiele zeichnen sich unter anderem dadurch aus, daß die Transparenz des beschichteten Substrats im wesentlichen der Transparenz eines Substrats ohne die Barrierebeschichtung entspricht. Dabei weicht die Lichttransmission durch ein beschichtetes Substrat von der Transmission eines Substrats ohne die Barrierebeschichtung im sichtbaren Spektralbereich um höchstens 5% ab. Auf diese Weise wird besonders vorteilhaft eine optische Unauffälligkeit der Barrierebeschichutng erreicht.

Fig. 5A zeigt dabei berechnete Spektralkurven in Transmission von feinlaminaren Schichtpaketen in Gestalt eines Wechselschichtpakets aus zwei kristallinen Schichtmaterialien. Die Barrierebeschichtung besteht dabei in allen Beispielen aus alternierenden Schichten aus SiO₂ (n = 1,455) und Al₂0₃ (n = 1,62) mit 20, 40, 80 und 160 Schichten auf Glas mit einem Brechungsindex von n = 1,52. Die Schichtdicken der Einzelschichten betragen im Beispiel der Fig. 5A jeweils 0,1 QWOT (Quarter Wave Optical Thickness) bei 550 Nanometer Wellenlänge, also je 9,45 nm für SiO₂ und je 8,5 nm für Al₂O₃, Die Gesamtdicken der sich daraus ergebenden Schichtpakete betragen 180 nm, 360 nm, 720 nm und 1440 nm. Die Transmission entspricht annähernd der Transmission des unbeschichteten Glassubstrates (ca. 92%).

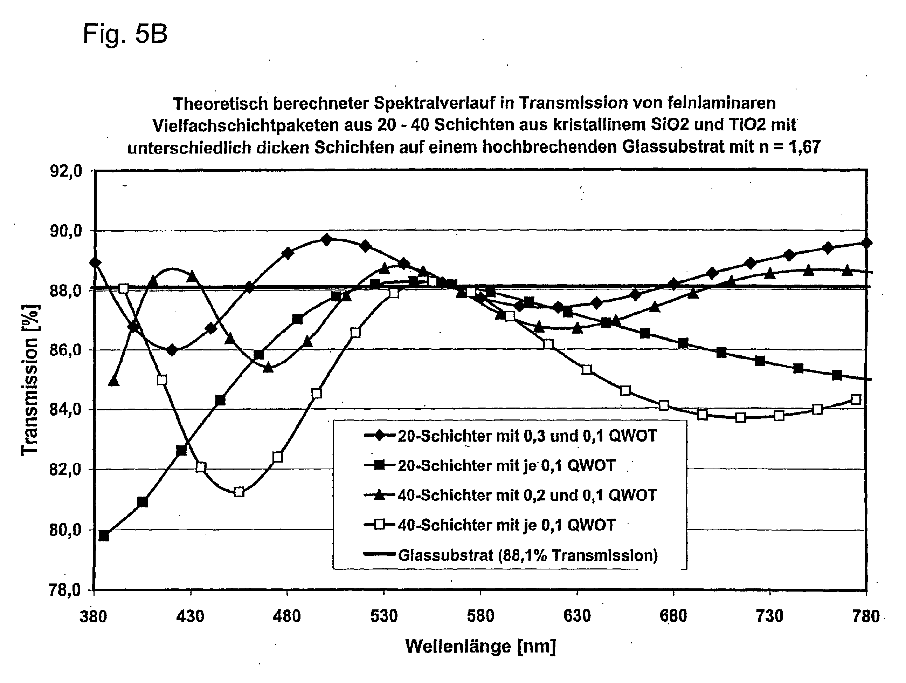

Fig. 5B zeigt berechnete Spektralkurven in Transmission von feinlaminaren Schichtpaketen aus zwei kristallinen Schichtmaterialien am Beispiel SiO₂ (n = 1,455) und TiO₂ (n = 2,40) mit 20 und 40 Schichten auf einem hochbrechenden Glas (n = 1,67). Die Schichtdicken der Einzelschichten sind in den vier berechneten Vielfachschichtpaketen der Barrierebeschichtung dabei so angepasst worden, dass sich jeweils eine möglichst hohe Transmission im für das menschliche Auge maximal empfindlichen Bereich um 550 nm herum ergibt. Dabei ergaben sich folgende Schichtdicken:
a) Für den ersten 20-Schichter: je 0,3 QWOT SiO₂, entsprechend 27 nm, und je 0,1 QWOT TiO₂, entsprechend 6 nm, Gesamtschichtdicke ca. 340 nm.
b) Für den zweiten 20-Schichter: je 0,1 QWOT für beide Materialien, entsprechend 9 nm SiO₂ und 6 nm TiO₂, Gesamtschichtdicke ca. 150 nm.
c) Für den ersten 40-Schichter: 0,2 QWOT Si02, entsprechend 19 nm, und für TiO₂ je 0,1 QWOT, entsprechend 6 nm, Gesamtschichtdicke etwa 500 nm.
d) Für den zweiten 40-Schichter: je 0,1 QWOT für beide Materialien, entsprechend 9 nm SiO₂ und 6 nm TiO₂, Gesamtschichtdicke ca. 300 nm

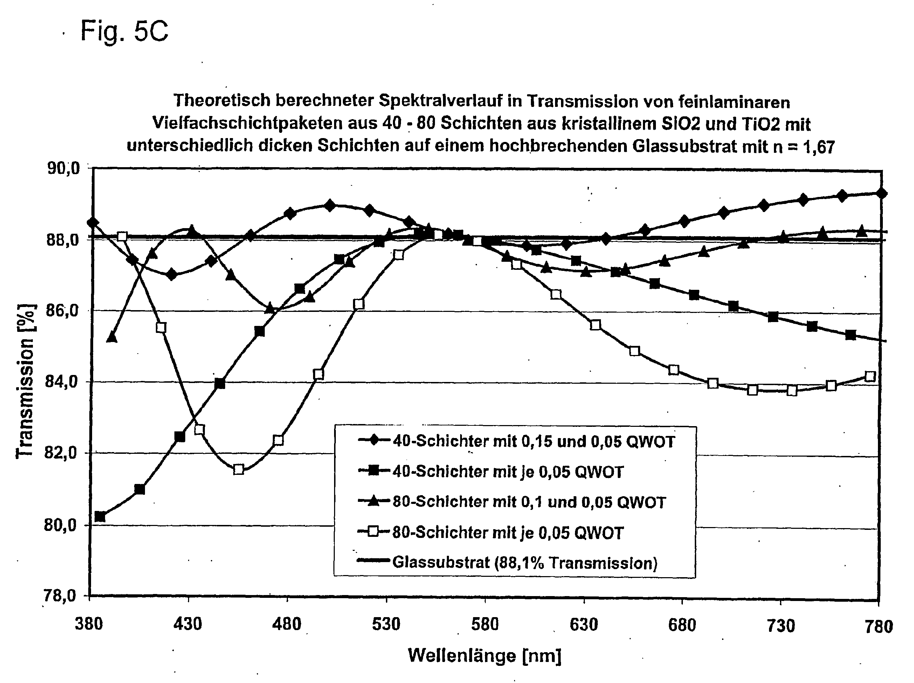

In Fig. 5C sind berechnete Spektralkurven in Transmission von feinlaminaren Schichtpaketen einer erfindungsgemäßen, als Wechselschichtsystem mit alternierenden Einzelschichten aus zwei kristallinen Schichtmaterialien am Beispiel SiO₂ (n = 1,455) und TiO₂ (n = 2,40) mit 40 und 80 Schichten auf einem hochbrechenden Glas (n = 1,67) dargestellt. Die Schichtdicken der Einzelschichten betragen dabei jeweils genau die Hälfte der Schichtdicken in Fig. 5B. Im Unterschied zu den in Fig. 5B dargestellten Beispielen sind dafür die Anzahlen der Einzelschichten jeweils verdoppelt worden, so daß die Gesamtschichtdicken der Barrierebeschichtungen denen der in Fig. 5B gezeigten Beispielen entsprechen.

Es ergeben sich dabei die folgenden Schichtdicken:
a) Für den ersten 40-Schichter: je 0,15 QWOT SiO₂, entsprechend 14 nm, und je 0,05 QWOT TiO₂, entsprechend 3 nm, Gesamtschichtdicke ca. 340 nm.
b) Für den zweiten 40-Schichter: je 0,05 QWOT für beide Materialien, entsprechend 4,5 nm SiO₂ und 3 nm TiO₂, Gesamtschichtdicke ca. 150 nm
c) Für den ersten 80-Schichter: 0,1 QWOT SiO₂, entsprechend 9 nm, und für TiO₂ je 0,05 QWOT, entsprechend 3 nm, Gesamtschichtdicke knapp 500 nm.
d) Für den zweiten 80-Schichter: je 0,05 QWOT für beide Materialien, entsprechend 4,5 nm SiO₂ und 3 nm TiO₂, Gesamtschichtdicke ca. 300 nm.

Anhand der in den Fig. 5A bis 5C dargestellten Transmissionsverläufe wird im folgenden gezeigt, dass es möglich ist, die Auswahl der verwendeten Schichtmaterialien für die Einzelschichten erfindungsgemäßer Barrierebeschichtungen so zu wählen, dass die Transmission des Gesamtsystems im sichtbaren Bereich der eines unbeschichteten Glassubstrates nach Möglichkeit entspricht, so dass durch die zusätzliche Barriereschutzbeschichtung keine wesentlichen Nachteile in Hinsicht auf die Transmission des beschichteten Substrates im Vergleich zu einem unbeschichteten Substrat entstehen.

So ist es beispielsweise vorteilhaft, Materialien für die Einzelschichten zu wählen, deren Brechwert in der Nähe des Brechwertes des verwendeten Glassubstrates liegen. Mit einem typischen Brechwert n von beispielsweise ca. n = 1,46 für Quarzglas, n = 1,52 für Floatglas und n = 1,6 - 1,7 für höherbrechende Gläser kommen insbesondere die beiden Schichtmaterialien SiO₂ mit n = 1,42 bis 1,46 (je nach Beschichtungsverfahren und Prozeßparametern) und Al₂O₃ (mit typischerweise n = 1,62) in Frage.

Mit Hilfe dieser beiden Materialien lassen sich leicht Schichtdickenkombinationen aus feinlaminaren Vielfachschichtpaketen mit dünnen, aufeinanderfolgenden Einzelschichten mit Schichtdicken von höchstens 50 Nanometern, insbesondere von höchstens 10 Nanometern oder sogar höchstens 2 Nanometern finden, deren Transmission im sichtbaren Bereich der des unbeschichteten Glassubstrates sehr nahe kommt. Als Transmission von unbeschichtetem Glas wird ungefähr 92%, je nach Glassorte angenommen. Dabei liegt die Transmission im sichtbaren Bereich einigermaßen unabhängig von der Anzahl der Schichtdicken und der Dicken der Einzelschichten immer in demselben Bereich wie das unbeschichtete Glassubstrat, wie in Fig. 5A gezeigt ist. Die Dicken der Einzelschichten könnten in Fig. 5A auch noch weiter verringert werden bei gleichzeitiger Beibehaltung der Gesamtschichtdicken der Schichtpakete, wenn dies zu einer weiteren Verbesserung der Barriereschutzwirkung führt, ohne dass sich dieses auf die Höhe der Transmission im sichtbaren Bereich nachteilig auswirken würde.

Kann ein Schichtmaterial durch Änderungen in den Prozessparametern beim Beschichtungsvorgang in zwei unterschiedlichen Modifikationen abgeschieden werden, z.B. in kristalliner und amorpher Modifikation wie beispielsweise feinstkristallines Quarz und glasartiges amorphes SiO₂, so können ebenfalls sehr leicht feinlaminare Vielfachschichtpakete gefunden werden, die nahezu keine Auswirkung auf die Transmission des beschichteten Glassubstrates haben, wenn der Brechwert der beiden Beschichtungsmaterialien in der Nähe des Brechwertes des Substrates liegt, in diesem Beispiel also auf Quarzglas oder auf einer anderen niedrigbrechenden Glassorte.

Können keine zwei Modifikationen eines Materials mit dem des Glassubstrates sehr ähnlichen Brechwerten gefunden werden, so können zwei Materialien mit einigermaßen ähnlichen Brechwerten-(siehe Fig.5A) oder auch zwei Materialien mit deutlich unterschiedlichen Brechwerten (siehe Fig. 5B und Fig. 5C) verwendet werden, wenn dabei die jeweiligen Schichtdicken der Einzelschichten in Hinsicht auf die optische Wirkung des Gesamtsystems angepasst sind. So ist es möglich, ein hochbrechendes Glassubstrat mit beispielsweise n = 1,67 in einem feinlaminaren Vielfachschichtsystem mit amorphen oder feinstkristallinen SiO₂-Schichten mit beispielsweise n = 1,45 und mit feinstkristallinen TiO₂-Schichten mit beispielsweise n = 2,40 zu beschichten, ohne dass die Transmission des Glassubstrates dadurch spürbar nachteilig beeinflusst wird.

Dabei müssen die Einzeldicken im Vielfachschichtpaket jeweils so gewählt werden, dass die Transmission im für das menschliche Auge maximal empfindlichen Bereich um 550 nm herum möglichst hoch ist, während eine leichte Abnahme der Transmission zu kürzeren oder längeren Wellenlängen hin den Gesamteindruck der Transparenz des beschichteten Glassubstrats für einen Betrachter nicht so auffällig beeinflusst, so wie es in Fig. 5B für einige theoretisch berechnete mögliche Ausführungsformen beispielsweise gezeigt ist.

Der Schichtdickenbereich der verwendeten Einzelschichten ist dabei nicht an einen vorgegebenen Bereich gebunden, um eine bestimmte optische Wirkung des beschichteten Substrates zu erreichen. Insbesondere können die Einzelschichtdicken bei gleichzeitiger Erhöhung der Anzahl der Einzelschichten auch verringert werden, wenn dieses zu einer Verbesserung der gesamten Diffusionsbarrierewirkung führen sollte.

Anhand von Fig. 5C ist gezeigt, dass sich die optische Wirkung der vier berechneten Ausführungsbeispiele auf die Transmission des Substrates hin praktisch nicht ändert, wenn die Schichtdicken der Einzelschichten in den vier Ausführungsbeispielen jeweils halbiert, die Anzahl der Einzelschichten dabei aber jeweils verdoppelt wird. Obwohl die optische Wirkung in den vier Beispielen jeweils annähernd identisch ist, kann der Einfluss auf die jeweilige Höhe der Diffusionsbarrierewirkung des Gesamtschichtsystems aufgrund der zunehmenden Anzahl von Einzelschichten jedoch erheblich sein.

Anders als in den Fig. 5A bis 5C dargestellt, können die Schichten aber auch so gewählt werden, daß die Barrierebeschichtung oder ein Entspiegelungsschichtsystem mit der Barrierebeschichtung entspiegelnd wirkt und damit sogar eine Steigerung der Transmission erzielt werden kann. Dazu wird ein entspiegelndes Gesamtschichtsystem hergestellt, bei welchem zumindest eine Schicht des Entspiegelungsschichtsystems durch ein erfindungsgemäßes Teilschichtpaket aus vielen dünnen, beziehungsweise feinlaminaren Einzelschichten realisiert wird, dessen effektiver Brechungsindex so bemessen ist, daß das ; Gesamtschichtsystem mit der Barrierebeschichtung insgesamt entspiegelnd wirkt. Die Dicke der Einzelschichten des Teilschichtsystems beträgt dabei durchschnittlich höchstens 50 Nanometer, bevorzugt sogar nur höchstens 10 Nanometer.

Dazu können die Schichten beispielsweise in ihrer Dicke und Zusammensetzung so gewählt werden, daß die gesamte Barriereschicht in ihrem Schichtaufbau Bedingungen entspricht, dass sie in ihrer optischen Gesamtwirkung insbesondere wieder im Bereich um 550 Nanometern Wellenlänge ein Maximum an Transmission erreicht. Dieses kann erfindungsgemäß erreicht werden, indem die für ein Entspiegelungssystem notwendige Schichtfolge zumindest teilweise durch eine Vielzahl von feinlaminaren Schichten ersetzt wird. Hierbei können zumindest teilweise die im Entspiegelungssystem notwendigen Schichten der Schichtfolge durch Vielfachschichten mit einem effektiven Brechungsindex, der sich aus dem Mittel der mit den Schichtdicken gewichteten Brechungsindizes der Vielfachschichten ergibt, ersetzt werden, ohne dass sich die optische Gesamtwirkung gegenüber dem Ausgangsdesign, also ohne Unterteilung in viele Einzelschichten merklich ändert. Die Diffusionssperrwirkung dieser erfindungsgemäß durch viele Einzelschichten realisierten Schichtfolge kann aber gegenüber dem betrachteten Ausgangsdesign, welches standardmäßig aus nur wenigen dickeren Schichten besteht, merklich verbessert sein.

Als Beispiel kann als Entspiegelungssystem von einem Schichtsystem mit vier Schichten ausgegangen werden, welches dem Fachmann bekannt ist und sich beispielsweise mit den beiden Schichtmaterialien TiO₂ (n = 2,40) und SiO₂ (n = 1,445) auf einem Glassubstrat mit einem Brechungsindex von n = 1,52 verwirklichen lässt. Eine hierzu mögliche Schichtdickenabfolge der vier Schichten kann beispielsweise sein (Angaben der optischen Schichtdicke der Einzelschichten in QWOT, dabei bezogen auf eine Referenzwellenlänge von 550 nm):

Substrat (n= 1,52)
0,216 QWOT Ti02 (12,5 nm)
0,384 QWOT Si02 (36,3 nm)
2,030 QWOT Ti02 (116,8 nm)
0,961 QWOT Si02 (90,8 nm)

Das Schichtsystem besteht damit aus 4 Schichten mit einer Gesamtdicke von 256 nm.

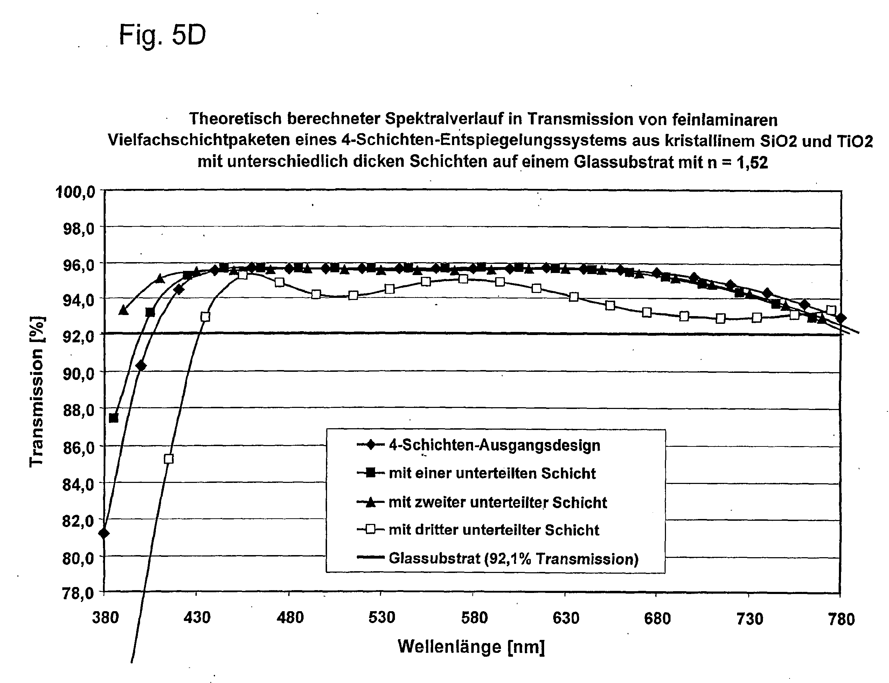

Die Fig. 5D zeigt den errechneten spektralen Verlauf für dieses beispielhaft ausgewählte Entspiegelungssystem, welches im sichtbaren Bereich von etwa 420 nm bis oberhalb von 700 nm entspiegelt und hierbei einen mittleren Transmissionswert von etwa 95,6% gegenüber dem unbeschichteten Glassubstrat (mit einer Transmission von 92,1% bei Brechungsindex n = 1,52) erreicht.

Die Rückseite des Substrates wurde bei dieser Betrachtung unbeschichtet gelassen, so dass eine Transmission oberhalb von 96% in diesem Beispiel prinzipiell nicht erreicht werden kann.

Es ist erfindungsgemäß nun möglich, einzelne oder sogar alle Schichten dieses Schichtsystems durch eine Abfolge von vielen Einzelschichten, also einem erfindungsgemäßen feinlaminaren Aufbau von Einzelschichten zu ersetzen, bei denen die betrachtete Schicht durch ein Schichtsystem mit einem effektiven Brechungsindex, der sich aus dem Mittel der mit den Schichtdicken gewichteten Brechungsindizes der Vielfachschichten ergibt, ersetzt wird.

Im angegebenen Fallbeispiel kann beispielsweise die zweite Schicht (SiO₂) durch eine Abfolge von mehreren Einzelschichten aus SiO₂ und TiO₂ ersetzt werden. Hierbei müssen die Einzelschichtdicken aus Si02 deutlich dicker sein als die aus TiO₂, damit sich in diesem Schichtpaket ein effektiver Brechungsindex einstellen lässt, der dem einer reinen SiO₂-Schicht möglichst ähnlich kommt.

Legt man beispielsweise fest, daß die SiO₂-Schicht durch drei sehr dünne Einzelschichten TiO₂ von jeweils genau 2 nm Dicke unterbrochen werden soll und passt die Schichtdicken der anderen Schichten für eine Optimierung an, so ergibt sich folgende Schichtabfolge:

Substrat (n = 1,52)
0,150 QWOT TiO₂ (8,7 nm)
4 Schichten-0,104 QWOT SiO₂ (9,8 nm), dreimal unterbrochen von jeweils 2 nm TiO₂
1,906 QWOT TiO₂ (109,9 nm)
0,946 QWOT SiO₂ (89,4 nm).

Das Schichtsystem umfaßt nun 11 Schichten mit einer Gesamtdicke von 255 nm, wobei die ersten acht Schichten einen erfindungsgemäßen feinlaminaren Schichtaufbau mit einer Vielzahl aufeinanderfolgender Einzelschichten mit weniger als 10 Nanometern Dicke darstellen.

Der errechnete spektrale Verlauf ist ebenfalls in Fig. 5D dargestellt. Er unterscheidet sich von dem betrachteten Ausgangsdesign im sichtbaren Bereich nur unwesentlich.

Es ist erfindungsgemäß möglich, außer einer Schicht weitere, Schichten einer Schichtfolge für eine Entspiegelung durch eine Vielzahl von Einzelschichten zu ersetzen. Im angegebenen Fallbeispiel kann insbesondere auch die dickste Schicht, die 109,9 nm dicke TiO₂-Schicht, durch eine passend gewählte Abfolge von feinlaminaren Einzelschichten ersetzt werden.

Legt man beispielsweise fest, dass die TiO₂-Schicht durch acht Schichten SiO₂ von jeweils genau 2 nm Dicke unterbrochen werden soll, und hält die im soeben durchgeführten Schritt erhaltenen Einzelschichten aus 9,8 nm SiO₂ und 2 nm TiO₂ fest und lässt nur noch die erste und die letzte Schicht des gesamten Schichtpaketes bei der Optimierung mit einem Schichtenberechnungsprogramm zusätzlich frei anpassen, so ergibt sich folgende Schichtabfolge:

Substrat (n = 1,52)
0,127 QWOT TiO₂ (7,3 nm)
4 Schichten 0,104 QWOT SiO₂ (9,8 nm), dreimal unterbrochen von jeweils 2 nm TiO₂
9 Schichten 0,180 TiO₂ (10,4 nm), achtmal unterbrochen von jeweils 2 nm SiO₂
0,939 QWOT SiO₂ (88,7 nm)

Das Schichtsystem umfaßt nun 27 Schichten mit einer Gesamtdicke von 252 nm.

Der errechnete spektrale Verlauf ist ebenfalls in Fig. 5D dargestellt. Er unterscheidet sich von dem betrachteten Ausgangsdesign im sichtbaren Bereich ebenfalls nur unwesentlich.

Es kann erfindungsgemäß auch die letzte im Schichtsystem verbleibende Schicht (89,4 nm SiO₂) noch in Einzelschichten unterteilt werden, falls dadurch die beabsichtigte Diffusionssperrwirkung des Gesamtschichtsystems noch weiter erhöht werden kann.

Legt man beispielsweise fest, dass die SiO₂-Schicht durch sechs Schichten TiO₂ von jeweils 2 nm unterbrochen werden soll und lässt die anderen Einzelschichten in der gesamten Schichtabfolge bis auf die 2 nm dünnen Einzelschichten gruppenweise bei der Optimierung mit einem Schichtenberechnungsprogramm frei anpassen, so ergibt sich folgende Schichtabfolge:

Substrat (n = 1,52)
0,255 QWOT TiO₂ (14,7 nm)
4 Schichten 0,092 QWOT SiO₂ (8,7 nm), dreimal unterbrochen von jeweils.2 nm TiO₂
9 Schichten 0,240 QWOT TiO₂ (13,8 nm), achtmal unterbrochen von jeweils 2 nm SiO₂
7 Schichten 0,117 QWOT SiO₂ (11,1 nm), sechsmal unterbrochen von jeweils 2 nm TiO₂.

Das Schichtsystem besteht aus 39 Schichten mit einer Gesamtdicke von 287 nm.

Der errechnete spektrale Verlauf ist ebenfalls in Fig. 5D dargestellt. Er unterscheidet sich von dem Verlauf des betrachteten Ausgangsdesigns im sichtbaren Bereich zwar deutlich, stellt aber immer noch ein wirkungsvolles Entspiegelungssystem im Vergleich zum unbeschichteten Substrat dar.

Die Diffusionssperrwirkung dieses Schichtsystems mit 39 Schichten kann gegenüber dem vorher betrachteten Schichtsystem mit nur 27 Schichten auf Grund der größeren Anzahl an Einzelschichten deutlich erhöht sein. Dieses Schichtsystem kann in Hinsicht auf die erfindungsgemäße Wirkung von Vorteil sein, auch wenn die

Entspiegelungswirkung der Diffusionsbarriereschicht dieses Beispiels nicht mehr ganz so gut ist wie die aus den vorherigen Beispielen.

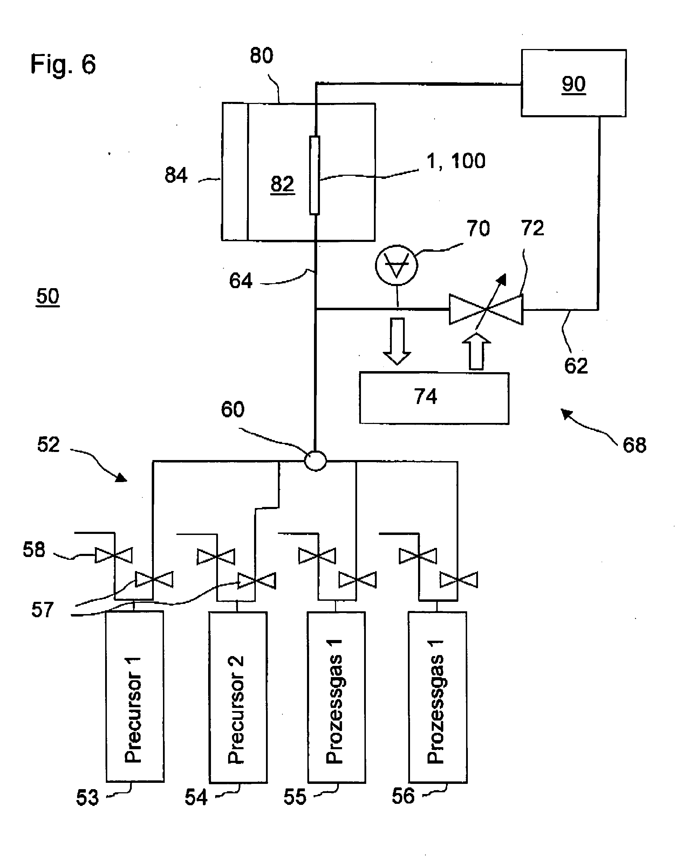

Fig. 6 zeigt schematisch eine Vorrichtung 50 zur CVD-Beschichtung von Substraten 1 mit einer Vielzahl aufeinanderfolgender dünner Schichten. Die Vorrichtung 1 umfasst einen Reaktor 80, der insbesondere für die Innenbeschichtung von hohlen Substraten, hier beispielhaft von Röhrchen 100 ausgebildet ist. Der Reaktor 80 ist dazu mit einer entsprechenden Halterung zur Aufnahme der Röhrchen und Leitung des Gases für die CVD-Beschichtung und optional für eine Plasmabehandlung aufgebrachter Schichten durch ein Röhrchen 100 hindurch ausgebildet. Die Vorrichtung 50 basiert darauf, daß eine Gasversorgung 52 mit mehreren Gasreservoirs in Form von Behältern 53 - 56 mittels ansteuerbarer Ventile 57 an einer mit einer Pumpe 90 verbundenen Hauptleitung 62 angeschlossen und der Reaktor 80 zur CVD-Beschichtung über eine von dieser Hauptleitung 62 abzweigende Zweigleitung 64 an die Gasversorgung 52 und mit der Pumpe 90 verbunden ist, um den Reaktor zu evakuieren und das Prozeßgas auszutauschen. Die Hauptleitung 62 weist dabei gegenüber der Zweigleitung 64 mit Reaktor 80 und darin aufgenommenem Röhrchen 100 einen niedrigeren Strömungswiderstand auf. Der gegenüber der Hauptleitung 62 höhere Strömungswiderstand durch Zweigleitung 64, Reaktor 80 und Röhrchen 100 wird dabei vor allem öder allein durch den kleinen Innendurchmesser des Röhrchens 100 verursacht.

Am Reaktor 80 ist weiterhin noch eine Einrichtung zur Einstrahlung elektromagnetischer Energie in den Reaktorraum zur Erzeugung des Plasmas im zugeführten Gas in Form eines Mikrowellenkopfes 84 vorgesehen, welcher vorzugsweise gepulst betrieben wird, um die Schichten mittels PICVD abzuscheiden und optional eine zusätzliche Plasmabehandlung zur Änderung der Schichtmorphologien der zuvor abgeschiedenen dünnen Einzelschichten durchzuführen.

Das Gasversorgungssystem 52 weist bei dem in Fig. 6 gezeigten Beispiel je zwei Gasbehälter 53, 54 mit Precursor-Gasen für die Schichtabscheidung, sowie zwei weitere Gasbehälter 55, 56 für Prozeßgase auf. Die Prozeßgase können beispielsweise ein Edelgas zur Beimischung zu einem der Precursor-Gase und ein Reaktivgas, insbesondere Sauerstoff sein. Sollen Titanoxid- und/oder Siliziumoxid-Schichten abgeschieden werden, können die Gasbehälter 53, 54 beispielsweise HMDSO (Hexamethyldisiloxan) für die Abscheidung von Siliziumoxid-Schichten und Titanchlorid für die Abscheidung von Titanoxid-Schichten eingesetzt werden. Mit den ansteuerbaren Ventilen 57 wird dann eine vorgesehene Gaszusammensetzung am Gasmischpunkt 60 am Anfang der Hauptleitung 62 erzeugt.

Die weiteren Ventile 58 dienen der Wartung, etwa, um nach einem Gasbehälterwechsel die Zuleitungen bis zu den Ventilen 57 zu spülen und evakuieren.

Die Gasmenge in der Hauptleitung wird mittels einer Druckregelung 68 durchgeführt. Diese umfaßt eine Steuerung 74, eine Druckmeßeinrichtung 70 und ein in der Hauptleitung 62 angeschlossenes Regelventil 72. Mit der Steuerung 74 der Druckregelung 68 wird dann der Druck in der Hauptleitung 62 auf einen Sollwert in Abhängigkeit von den mit der Druckmeßeinrichtung 70 aufgenommenen Druckmeßwerten durch Ansteuerung des Regelventils eingeregelt.

Durch den niedrigeren Strömungswiderstand der Hauptleitung 62 kann auch am Abzweig der Zweigleitung 64 von der Hauptleitung 62 sehr schnell ein Wechsel des Gases oder Gasgemischs für die Erzeugung von Einzelschichten unterschiedlicher Beschaffenheit und/oder einer Plasmabehandlung zuvor abgeschiedener Schichten, insbesondere in einem Reaktivgas durchgeführt werden, um deren Morphologie zu verändern.

Die Höhe des Gasflusses durch das Substrat 100 in der von der Hauptleitung 62 abzweigenden Zweigleitung ergibt sich dann in Abhängigkeit der Strömungswiderstände durch einerseits das schmale Röhrchen, und andererseits durch die Hauptleitung, also insbesondere als eine Funktion der effektiven Öffnungsquerschnitte der beiden Gasfluss-Zweige.

Neben der Abscheidung von Barrierebeschichtungen auf der Innenseite von Röhrchen kann die Vorrichtung auch zur Abscheidung von photokatalytisch wirksamen Schichtstapeln mit erfindungsgemäßer feinlaminarer Struktur mit einer Schichtdicke der Einzelschichten von höchstens 50 Nanometern verwendet werden. Derartige innen- und/oder außenbeschichtete Röhrchen können dann beispielsweise zu einem katalytisch wirkenden Luft- oder Abgasfilter, beispielsweise zur Reduktion von Ozon für den Einsatz in Kraftfahrzeugen zusammengesetzt werden. Auch können Fasermaterialien, wie Glasfaser- oder Mineralfaservliese oder Gewebe als Substrat in der vorstehend beschriebenen Vorrichtung mit erfindungsgemäßen feinlaminaren Beschichtungen, etwa ebenfalls für Anwendungen als Katalysator beschichtet werden.

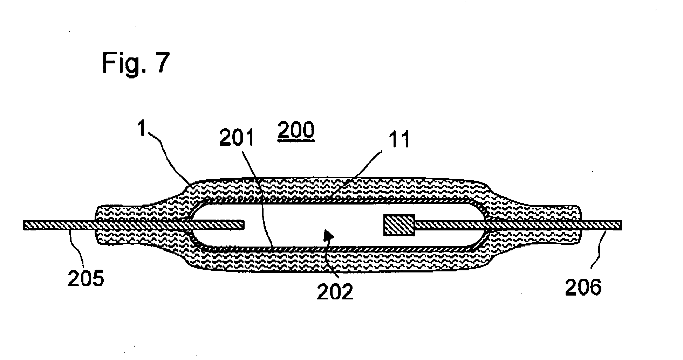

Fig. 7 zeigt ein Beispiel einer Lampe 200 mit einem Substrat 1 in Form eines beschichteten Lampenkolbens. Zur Herstellung einer solchen Lampe wird zunächst wie anhand von Fig. 6 beschrieben wurde, ein röhrenformiges Substrat, beziehungsweise Röhrchen 100 innenseitig beschichtet. Zweckmäßigerweise wird zur Herstellung einer Lampe 200 dazu ein Glasröhrchen, beispielsweise aus Quarzglas verwendet. Anschließend werden die Anschlußdrähte 205, 206 in die offenen Röhrchenenden eingesetzt und die Enden dann durch Erhitzung aufgeweicht und zusammengequetscht, so daß ein abgeschlossener Hohlraum 202 geformt wird, dessen Innenseite mit der erfindungsgemäßen feinlaminaren Barriereschicht 11 versehen ist. Diese Vorgehensweise, also erst die Innenbeschichtung vorzunehmen und dann aus dem Röhrchen einen ein- oder wie in diesem Beispiel beidseitig abgeschlossenen Hohlraum zu formen, ist vorteilhaft, um einen hinreichenden Durchfluß des oder der Gase für die Beschichtung zu erhalten. Die Reihenfolge der Schritte des Innenbeschichtens und Zusammenquetschens ist an der fertigen Lampe unter anderem daran zu erkennen, daß sich die Innenbeschichtung im Quetschbereich, dort wo die Innenfläche 201 auf die eingeschmolzenen Anschlußdrähte trifft, aufgrund der Verformung in das Substrat 1 hineinzieht.

Es ist dem Fachmann ersichtlich, daß die Erfindung nicht auf die vorstehend beschriebenen Ausführungsbeispiele beschränkt ist. Vielmehr können die Ausführungsbeispiele in vielfältiger Weise geändert und insbesondere auch die Merkmale der einzelnen Ausführungsbeispiele miteinander kombniert werden.

## Patentansprüche

1. Beschichtetes Substrat, **gekennzeichnet durch** eine Beschichtung, insbesondere eine Barrierebeschichtung mit einer Vielzahl aufeinanderfolgender Einzelschichten, welche jeweils eine sich gegenüber einer benachbarten Einzelschicht unterscheidende oder gleichartige Beschaffenheit aufweisen, wobei die Einzelschichten eine Schichtdicke von jeweils höchstens 50 Nanometern aufweisen, **dadurch gekennzeichnet, daß** das Substrat ein nach dem Beschichten unter Bildung eines abgeschlossenen Hohlraums heiß zusammengequetschtes Rohr ist.

2. Beschichtetes Substrat gemäß Anspruch 1, **dadurch gekennzeichnet, daß** zumindest eine der Einzelschichten, bevorzugt mehrere Einzelschichten, insbesondere mehrere aufeinanderfolgende Einzelschichten, insbesondere auch alle Einzelschichten der Beschichtung, insbesondere Barrierebeschichtung eine Schichtdicke von höchstens 10 Nanometern aufweisen.

3. Beschichtetes Substrat gemäß Anspruch 1 oder 2, **dadurch gekennzeichnet, daß** zumindest eine der Einzelschichten, bevorzugt mehrere Einzelschichten, insbesondere mehrere aufeinanderfolgende Einzelschichten, insbesondere auch alle Einzelschichten der Beschichtung, insbesondere Barrierebeschichtung eine Schichtdicke von höchstens 2 Nanometern, bevorzugt auch kleiner 2 Nanometern aufweisen.

4. Beschichtetes Substrat gemäß einem der vorstehenden Ansprüche, **dadurch gekennzeichnet, daß** zumindest eine Einzelschicht der Beschichtung, insbesondere Barrierebeschichtung sich von einer benachbarten Einzelschicht durch ihre chemische Zusammensetzung unterscheidet.

5. Beschichtetes Substrat gemäß einem der vorstehenden Ansprüche, **dadurch gekennzeichnet, daß** zumindest eine der Einzelschichten kristalline, insbesondere feinstkristalline oder teilkristalline Struktur aufweist.

6. Beschichtetes Substrat gemäß Anspruch 5, **gekennzeichnet durch** eine Schicht mit mehreren aufeinanderfolgenden, gleichartigen kristallinen Schichten.

7. Beschichtetes Substrat gemäß einem der vorstehenden Ansprüche, **dadurch gekennzeichnet, daß** zumindest eine Einzelschicht der Beschichtung, insbesondere Barrierebeschichtung sich von einer benachbarten Einzelschicht durch ihre Morphologie unterscheidet.

8. Beschichtetes Substrat gemäß Anspruch 7, **dadurch gekennzeichnet, daß** sich die Einzelschicht von einer benachbarten Einzelschicht durch ihre Kristallstruktur unterscheidet.

9. Beschichtetes Substrat gemäß einem der vorstehenden Ansprüche, **dadurch gekennzeichnet, daß** die Barrierebeschichtung zumindest ein Teilschichtpaket mit Einzelschichten gleicher Zusammensetzung, aber unterschiedlicher Morphologie umfaßt.

10. Beschichtetes Substrat gemäß einem der vorstehenden Ansprüche, **dadurch gekennzeichnet, daß** die Einzelschichten sich durch ihren Wachstumsmodus unterscheiden.

11. Beschichtetes Substrat gemäß einem der vorstehenden Ansprüche, **dadurch gekennzeichnet, daß** zumindest eine der Einzelschichten amorphe oder zumindest teilamorphe Struktur aufweist.

12. Beschichtetes Substrat gemäß Anspruch 11, **gekennzeichnet durch** eine Schicht mit mehreren aufeinanderfolgenden, gleichartigen, zumindest teilamorphen Schichten.

13. Beschichtetes Substrat gemäß einem der vorstehenden Ansprüche, **dadurch gekennzeichnet, daß** die Beschichtung, insbesondere Barrierebeschichtung zumindest ein Teilschichtpaket mit abwechselnden Schichten unterschiedlicher Beschaffenheit umfaßt.

14. Beschichtetes Substrat gemäß einem der vorstehenden Ansprüche, **dadurch gekennzeichnet, daß** die Barrierebeschichtung zumindest ein Teilschichtpaket mit amorphen und benachbarten, zumindest teilkristallinen, bevorzugt feinstkristallinen Schichten umfaßt.

15. Beschichtetes Substrat gemäß einem der vorstehenden Ansprüche, **dadurch gekennzeichnet, daß** die Barrierebeschichtung zumindest ein Teilschichtpaket mit zwei zumindest teilkristallinen, bevorzugt feinstkristalllinen Schichten unterschiedlicher Zusammensetzung umfaßt, zwischen denen jeweils eine amorphe Schicht angeordnet ist.

16. Beschichtetes Substrat gemäß einem der vorstehenden Ansprüche, **dadurch gekennzeichnet, daß** die Beschichtung, insbesondere Barrierebeschichtung transparent ist.

17. Beschichtetes Substrat gemäß einem der vorstehenden Ansprüche, **gekennzeichnet durch** ein transparentes Substrat.

18. Beschichtetes Substrat gemäß Anspruch 16 oder 17, **dadurch gekennzeichnet, daß** die Transparenz der Beschichtung, insbesondere Barrierebeschichtung der Transparenz des Substrats entspricht.

19. Beschichtetes Substrat gemäß einem der Ansprüche 16 bis 18, **dadurch gekennzeichnet, daß** die Lichttransmission durch ein beschichtetes Substrat von der Transmission eines Substrats ohne die Beschichtung, insbesondere Barrierebeschichtung im sichtbaren Spektralbereich um höchstens 5% abweicht.

20. Beschichtetes Substrat gemäß einem der vorstehenden Ansprüche, **dadurch gekennzeichnet, daß** der Brechungsindex der Beschichtung, insbesondere Barrierebeschichtung dem Brechungsindex der Substratoberfläche entspricht oder von diesem um höchstens 5 % abweicht.

21. Beschichtetes Substrat gemäß einem der vorstehenden Ansprüche, **gekennzeichnet durch** ein Entspiegelungsschichtsystem mit der Beschichtung, insbesondere Barrierebeschichtung, wobei das Gesamtschichtsystem entspiegelnd wirkt und zumindest eine Schicht des Entspiegelungsschichtsystems ein Teilschichtpaket mit einer Vielzahl dünner aufeinanderfolgender Schichten mit einer durchschnittlichen Dicke der Einzelschichten von höchstens 50 Nanometern umfaßt, dessen effektiver Brechungsindex so bemessen ist, daß das Entspiegelungsschichtsystem insgesamt entspiegelnd wirkt.

22. Beschichtetes Substrat gemäß einem der vorstehenden Ansprüche, **dadurch gekennzeichnet, daß** zumindest eine der Einzelschichten, bevorzugt alle Einzelschichten anorganische Oxide enthalten, insbesondere anorganische Oxidschichten sind.

23. Beschichtetes Substrat gemäß einem der vorstehenden Ansprüche, **dadurch gekennzeichnet, daß** zumindest eine der Einzelschichten wenigstens eines der Oxide TiO₂, ZrO₂, Si02, A1203, Nb₂O₅, Ta₂O₅, HfO₂ enthält.

24. Beschichtetes Substrat gemäß einem der vorstehenden Ansprüche, **dadurch gekennzeichnet, daß** das Substrat zumindest eines der Materialien Glas, Glaskeramik, Keramik, Metall, Halbleiter, einen kristallinen Werkstoff umfaßt.

25. Beschichtetes Substrat gemäß einem der vorstehenden Ansprüche, **dadurch gekennzeichnet, daß** das Substrat hohl ist.

26. Beschichtetes Substrat gemäß einem der vorstehenden Ansprüche, **dadurch gekennzeichnet, daß** das Substrat röhrenförmig ist.

27. Beschichtetes Substrat gemäß Anspruch 25 oder 26, **dadurch gekennzeichnet, daß** das Substrat innenbeschichtet ist.

28. Beschichtetes Substrat gemäß einem der vorstehenden Ansprüche, **dadurch gekennzeichnet, daß** die Beschichtung katalytisch wirksam, insbesondere photokatalytisch wirksam ist.

29. Beschichtetes Substrat gemäß Anspruch 28, **gekennzeichnet, durch** Titanoxid-haltige photokatalytisch wirksame Einzelschichten.

30. Katalysator, insbesondere Luftfilter, umfassend ein Substrat gemäß einem der vorstehenden Ansprüche.

31. Verfahren zur Herstellung einer Beschichtung, insbesondere Barrierebeschichtung auf einem Substrat, insbesondere zur Herstellung eines beschichteten Substrats gemäß einem der vorstehenden Ansprüche, bei welchem zur Herstellung der Barrierebeschichtung eine Vielzahl von aufeinanderfolgenden Einzelschichten abgeschieden wird, die jeweils eine sich gegenüber einer benachbarten Einzelschicht unterscheidende oder gleichartige Beschaffenheit aufweisen und deren Schichtdicke jeweils höchstens 50 Nanometer beträgt, **dadurch gekennzeichnet, daß** ein röhrenförmiges Substrat beschichtet und nach der Beschichtung aufgeheizt und zusammengequetscht wird.

32. Verfahren gemäß Anspruch 31, **dadurch gekennzeichnet, daß** zumindest eine der Einzelschichten, bevorzugt mehrere Einzelschichten, insbesondere mehrere aufeinanderfolgende Einzelschichten, insbesondere auch alle Einzelschichten der Beschichtung, insbesondere der Barrierebeschichtung mit einer Schichtdicke von höchstens 10 Nanometern abgeschieden werden.

33. Verfahren gemäß Anspruch 31 oder 32, **dadurch gekennzeichnet, daß** zumindest eine der Einzelschichten, bevorzugt mehrere Einzelschichten, insbesondere mehrere aufeinanderfolgende Einzelschichten, insbesondere auch alle Einzelschichten der Barrierebeschichtung mit einer Schichtdicke von höchstens 2 Nanometern, bevorzugt auch kleiner 2 Nanometern abgeschieden werden.

34. Verfahren gemäß einem der vorstehenden Ansprüche, **dadurch gekennzeichnet, daß** die Einzelschichten mittels zumindest einem Vakuumabscheideverfahren abgeschieden werden.

35. Verfahren gemäß Anspruch 34, **dadurch gekennzeichnet, daß** zumindest ein Teil der Einzelschichten mit plasmaimpuls-unterstützter Dampfphasenabscheidung abgeschieden werden.

36. Verfahren gemäß Anspruch 34 oder 35, **dadurch gekennzeichnet, daß** zumindest ein Teil der Einzelschichten aufgesputtert wird.

37. Verfahren gemäß einem der vorstehenden Ansprüche, **dadurch gekennzeichnet, daß** aufeinanderfolgend Schichten unterschiedlicher Morphologie durch Wechsel der Prozeßparameter von einer Schicht zu einer nachfolgenden Schicht abgeschieden werden.

38. Verfahren gemäß Anspruch 37, **dadurch gekennzeichnet, daß** durch Wechsel der Prozeßparameter Einzelschichten mit unterschiedlichem Wachstumsmodus abgeschieden werden.

39. Verfahren gemäß einem der vorstehenden Ansprüche, **dadurch gekennzeichnet, daß** zumindest eine amorphe Einzelschicht abgeschieden wird.

40. Verfahren gemäß einem der vorstehenden Ansprüche, **dadurch gekennzeichnet, daß** zumindest eine wenigstens teilkristalline, bevorzugt feinstkristalline Einzelschicht abgeschieden wird.

41. Verfahren gemäß einem der vorstehenden Ansprüche, **dadurch gekennzeichnet, daß** zumindest ein Teilschichtpaket der Barrierebeschichtung mit abwechselnden Schichten unterschiedlicher Beschaffenheit abgeschieden wird.

42. Verfahren gemäß einem der vorstehenden Ansprüche, **dadurch gekennzeichnet, daß** zumindest ein Teilschichtpaket der Barrierebeschichtung mit zwei zumindest teilkristallinen, bevorzugt feinstkristalllinen Schichten unterschiedlicher Zusammensetzung, zwischen denen jeweils eine amorphe Schicht angeordnet ist, abgeschieden wird.

43. Verfahren gemäß einem der vorstehenden Ansprüche, **dadurch gekennzeichnet, daß** zwischen den Beschichtungsschritten für die Beschichtung der Einzelschichten eine andere Gaszusammensetzung als diejenige, die für den Beschichtungsvorgang verwendet wird, eingeleitet und dann mittels Energieeinkopplung durch eine Plasmabehandlung eine Beeinflussung der Morphologie einer zuvor aufgewachsenen Einzelschicht durchgeführt wird.

44. Verfahren gemäß Anspruch 43, **dadurch gekennzeichnet, daß** eine Gaszusammensetzung für die Plasmabehandlung eingeleitet wird, welche ein Reaktivgas enthält.

45. Verfahren gemäß Anspruch 44, **dadurch gekennzeichnet, daß** eine Gaszusammensetzung für die Plasmabehandlung eingeleitet wird, welche Sauerstoff-Gas enthält.

46. Verfahren gemäß einem der Ansprüche 43 bis 45, **dadurch gekennzeichnet, daß** bei der Plasmabehandlung gepulste elektromagnetische Energie zur Erzeugung des Plasmas verwendet wird.

47. Verfahren gemäß einem der Ansprüche 43 bis 46, **dadurch gekennzeichnet, daß** die Einzelschicht mittels der Plasmabehandlung zum teilweisen oder vollständigen Kristallisieren gebracht wird.

48. Verfahren gemäß einem der Ansprüche 43 bis 47, **dadurch gekennzeichnet, daß** eine kristalline Einzelschicht abgeschieden und mittels der Plasmabehandlung in eine zumindest teilamorphe Einzelschicht umgewandelt wird.

49. Verfahren gemäß einem der Ansprüche 43 bis 48, **dadurch gekennzeichnet, daß** eine kristalline Einzelschicht abgeschieden und mittels der Plasmabehandlung in eine Schicht mit anderer kristalliner Phase oder Morphologie umgewandelt wird.

50. Verfahren gemäß einem der vorstehenden Ansprüche, bei welchem für die Erzeugung dickerer Schichten aus unterschiedlichen oder gleichartigen Einzelschichten mit Schichtdicken bis vorzugsweise höchstens 50 Nanometer die Schritte des Abscheidens einer Einzelschicht und des Plasmabehandelns dieser Einzelschicht mehrmals wiederholt werden.

51. Verfahren gemäß einem der vorstehenden Ansprüche, **dadurch gekennzeichnet, daß** ein hohles, insbesondere röhrenförmiges Substrat beschichtet wird.

52. Verfahren gemäß Anspruch 51, **dadurch gekennzeichnet, daß** ein Lampenkolben beschichtet wird.

53. Verfahren gemäß Anspruch 51 oder 52, **dadurch gekennzeichnet, daß** das Substrat innenbeschichtet wird.

54. Verfahren gemäß einem der Ansprüche 31 bis 53, **dadurch gekennzeichnet, daß** mit dem Zusammenquetschen ein Lampenkolben hergestellt wird.

55. Verfahren gemäß einem der vorstehenden Ansprüche, **dadurch gekennzeichnet, daß** photokatalytisch wirksame Einzelschichten abgeschieden werden.

56. Verfahren gemäß einem der vorstehenden Ansprüche, **dadurch gekennzeichnet, daß** photokatalytisch wirksame Titanoxid-haltige Einzelschichten abgeschieden werden.

57. Verfahren gemäß einem der vorstehenden Ansprüche, zur plasmaunterstützten CVD-Beschichtung von Substraten, bei welcher das Substrat in einem Reaktor angeordnet wird, wobei das Gas für die Plasmabeschichtung oder Plasmabehandlung dem Reaktorraum über eine Zweigleitung zugeführt wird, welche an eine Hauptleitung angeschlossen ist, durch welche mittels eines Gasversorgungssystems das Gas oder Gasgemisch für die CVD-Beschichtung bereitgestellt wird und welche gegenüber der Zweigleitung mit Reaktor und darin aufgenommenem Substrat einen niedrigeren Strömungswiderstand aufweist, und wobei mittels Einstrahlung elektromagnetischer Energie im Prozeßgas im Reaktor ein Plasma für die Beschichtung oder Plasmabehandlung erzeugt wird, und wobei Haupt- und Zweigleitung über zumindest eine Pumpe abgepumpt werden.

58. Verfahren gemäß Anspruch 57, **dadurch gekennzeichnet, daß** eine Druckregelung mit einer Druckmeßeinrichtung und einem in der Hauptleitung angeschlossenen Regelventil, zur Einregelung des Drucks in der Hauptleitung auf einen Sollwert in Abhängigkeit von den mit der Druckmeßeinrichtung aufgenommenen Druckmeßwerten erfolgt.

59. Verfahren gemäß Anspruch 58, **dadurch gekennzeichnet, daß** die Druckregelung mittels eines hinter dem Abzweig der Zweigleitung angeordneten Regelventils erfolgt.

## Claims

1. Coated substrate, **characterised by** a coating, in particular a barrier coating having a multiplicity of consecutive individual layers which each have a different or similar character with respect to an adjacent individual layer, wherein the individual layers have a layer thickness of at most 50 nanometres in each case, **characterised in that** the substrate is a tube which is heat-pressed together after the coating procedure thus forming a closed hollow space.

2. Coated substrate as claimed in claim 1, **characterised in that** at least one of the individual layers, preferably several individual layers, in particular several consecutive individual layers, in particular also all of the individual layers of the coating, in particular the barrier coating, have a layer thickness of at most 10 nanometres.

3. Coated substrate as claimed in claim 1 or 2, **characterised in that** at least one of the individual layers, preferably several individual layers, in particular several consecutive individual layers, in particular also all of the individual layers of the coating, in particular the barrier coating, have a layer thickness of at most 2 nanometres, preferably also less than 2 nanometres.

4. Coated substrate as claimed in any one of the preceding claims, **characterised in that** at least one individual layer of the coating, in particular the barrier coating, differs from an adjacent individual layer by virtue of its chemical composition.

5. Coated substrate as claimed in any one of the preceding claims, **characterised in that** at least one of the individual layers has a crystalline, in particular fine-crystalline or partially crystalline structure.

6. Coated substrate as claimed in claim 5, **characterised by** a layer having several consecutive, similar crystalline layers.

7. Coated substrate as claimed in any one of the preceding claims, **characterised in that** at least one individual layer of the coating, in particular the barrier coating, differs from an adjacent individual layer by virtue of its morphology.

8. Coated substrate as claimed in claim 7, **characterised in that** the individual layer differs from an adjacent individual layer by virtue of its crystal structure.

9. Coated substrate as claimed in any one of the preceding claims, **characterised in that** the barrier coating has at least one partial layer packet having individual layers of identical composition but different morphology.

10. Coated substrate as claimed in any one of the preceding claims, **characterised in that** the individual layers differ by virtue of their growth mode.

11. Coated substrate as claimed in any one of the preceding claims, **characterised in that** at least one of the individual layers has an amorphous or at least partially amorphous structure.

12. Coated substrate as claimed in claim 11, **characterised by** a layer having several consecutive, similar, at least partially amorphous layers.

13. Coated substrate as claimed in any one of the preceding claims, **characterised in that** the coating, in particular the barrier coating, has at least one partial layer packet having alternate layers of a different character.

14. Coated substrate as claimed in any one of the preceding claims, **characterised in that** the barrier coating has at least one partial layer packet having amorphous and adjacent, at least partially crystalline, preferably fine-crystalline layers.

15. Coated substrate as claimed in any one of the preceding claims, **characterised in that** the barrier coating has at least one partial layer packet having two at least partially crystalline, preferably fine-crystalline layers of different composition, between which an amorphous layers is disposed in each case.

16. Coated substrate as claimed in any one of the preceding claims, **characterised in that** the coating, in particular the barrier coating, is transparent.

17. Coated substrate as claimed in any one of the preceding claims, **characterised by** a transparent substrate.

18. Coated substrate as claimed in claim 16 or 17, **characterised in that** the transparency of the coating, in particular the barrier coating, corresponds to the transparency of the substrate.

19. Coated substrate as claimed in any one of claims 16 to 18, **characterised in that** the light transmission through a coated substrate deviates within the visible spectral range by a maximum of 5% from the transmission of a substrate without the coating, in particular the barrier coating.

20. Coated substrate as claimed in any one of the preceding claims, **characterised in that** the refractive index of the coating, in particular the barrier coating, corresponds to the refractive index of the substrate surface or deviates therefrom by a maximum of 5%.

21. Coated substrate as claimed in any one of the preceding claims, **characterised by** an antireflection coating-layer system having the coating, in particular the barrier coating, wherein the entire layer system functions in a reflection-reducing manner and at least one layer of the antireflection coating-layer system has a partial layer packet having a multiplicity of thin, consecutive layers having an average thickness of the individual layers of at most 50 nanometres, whose effective refractive index is dimensioned in such a manner that the antireflection coating-layer system functions overall in a reflection-reducing manner.

22. Coated substrate as claimed in any one of the preceding claims, **characterised in that** at least one of the individual layers, preferably all of the individual layers contain inorganic oxides, in particular they are inorganic oxide layers.

23. Coated substrate as claimed in any one of the preceding claims, **characterised in that** at least one of the individual layers contains at least one of the following oxides: TiO₂, ZrO₂, SiO₂, Al₂O₃, Nb₂O₅, Ta₂O₅, HfO₂.

24. Coated substrate as claimed in any one of the preceding claims, **characterised in that** the substrate has at least one of the following materials: glass, glass ceramics, ceramics, metal, semiconductor, a crystalline substance.

25. Coated substrate as claimed in any one of the preceding claims, **characterised in that** the substrate is hollow.

26. Coated substrate as claimed in any one of the preceding claims, **characterised in that** the substrate is tubular.

27. Coated substrate as claimed in claim 25 or 26, **characterised in that** the substrate is internally coated.

28. Coated substrate as claimed in any one of the preceding claims, **characterised in that** the coating is catalytically effective, in particular photo-catalytically effective.

29. Coated substrate as claimed in claim 28, **characterised by** titanium oxide-containing, photo-catalytically effective individual layers.

30. Catalyst, in particular an air filter, comprising a substrate as claimed in any one of the preceding claims.

31. Method for producing a coating, in particular a barrier coating on a substrate, in particular for producing a coated substrate as claimed in any one of the preceding claims, in which in order to produce the barrier coating a multiplicity of consecutive individual layers is deposited which each have a different or similar character with respect to an adjacent individual layer and whose layer thickness amounts in each case to at most 50 nanometres, **characterised in that** a tubular substrate is coated and, after coating, is heated and pressed together.

32. Method as claimed in claim 31, **characterised in that** at least one of the individual layers, preferably several individual layers, in particular several consecutive individual layers, in particular also all of the individual layers of the coating, in particular the barrier coating, having a layer thickness of at most 10 nanometres are deposited.

33. Method as claimed in claim 31 or 32, **characterised in that** at least one of the individual layers, preferably several individual layers, in particular several consecutive individual layers, in particular also all of the individual layers of the barrier coating, having a layer thickness of at most 2 nanometres, preferably even less than 2 nanometres, is/are deposited.

34. Method as claimed in any one of the preceding claims, **characterised in that** the individual layers are deposited by means of at least one vacuum deposition process.

35. Method as claimed in claim 34, **characterised in that** at least some of the individual layers are deposited by means of plasma pulse-assisted vapour phase deposition.

36. Method as claimed in claim 34 or 35, **characterised in that** at least some of the individual layers are sputtered on.

37. Method as claimed in any one of the preceding claims, **characterised in that** layers of different morphology are deposited consecutively by changing the process parameters from one layer to a subsequent layer.

38. Method as claimed in claim 37, **characterised in that** individual layers having a different growth mode are deposited by changing the process parameters.

39. Method as claimed in any one of the preceding claims, **characterised in that** at least one amorphous individual layer is deposited.

40. Method as claimed in any one of the preceding claims, **characterised in that** at least one at least partially crystalline, preferably fine-crystalline individual layer is deposited.

41. Method as claimed in any one of the preceding claims, **characterised in that** at least one partial layer packet of the barrier coating having alternate layers of a different character is deposited.

42. Method as claimed in any one of the preceding claims, **characterised in that** at least one partial layer packet of the barrier coating having two at least partially crystalline, preferably fine-crystalline layers of different composition is deposited, between which an amorphous layer is disposed in each case.

43. Method as claimed in any one of the preceding claims, **characterised in that** between the coating steps for coating the individual layers a different gas composition than the one used for the coating procedure is introduced, and then by means of coupling-in energy the morphology of a previously grown individual layer is influenced by means of a plasma treatment.

44. Method as claimed in claim 43, **characterised in that** a gas composition which contains a reactive gas is introduced for the plasma treatment.

45. Method as claimed in claim 44, **characterised in that** a gas composition which contains oxygen gas is introduced for the plasma treatment.

46. Method as claimed in any one of claims 43 to 45, **characterised in that** during the plasma treatment pulsed electromagnetic energy is used to produce the plasma.

47. Method as claimed in any one of claims 43 to 46, **characterised in that** the plasma treatment causes the individual layer to crystallise partially or completely.

48. Method as claimed in any one of claims 43 to 47, **characterised in that** a crystalline individual layer is deposited and is converted by means of the plasma treatment into an at least partially amorphous individual layer.

49. Method as claimed in any one of claims 43 to 48, **characterised in that** a crystalline individual layer is deposited and is converted by means of the plasma treatment into a layer having a different crystalline phase or morphology.

50. Method as claimed in any one of the preceding claims, in which in order to produce thicker layers of different or similar individual layers having layer thicknesses up to preferably at most 50 nanometres the steps of depositing an individual layer and of plasma-treating this individual layer are repeated several times.

51. Method as claimed in any one of the preceding claims, **characterised in that** a hollow, in particular tubular substrate is coated.

52. Method as claimed in claim 51, **characterised in that** a lamp bulb is coated.

53. Method as claimed in claim 51 or 52, **characterised in that** the substrate is internally coated.

54. Method as claimed in any one of claims 31 to 53, **characterised in that** a lamp bulb is produced by pressing it together.

55. Method as claimed in any one of the preceding claims, **characterised in that** the photo-catalytically effective individual layers are deposited.

56. Method as claimed in any one of the preceding claims, **characterised in that** photo-catalytically effective, titanium oxide-containing individual layers are deposited.

57. Method as claimed in any one of the preceding claims, for plasma-assisted CVD-coating of substrates, in which the substrate is disposed in a reactor, wherein the gas for the plasma-coating or the plasma treatment is supplied to the reactor chamber via a branch line which is connected to a main line, through which by means of a gas supply system the gas or gas mixture is provided for the CVD-coating and which has a lower flow resistance compared to the branch line with the reactor and substrate accommodated therein, and wherein by the irradiation of electromagnetic energy in the process gas in the reactor a plasma is produced for the coating or the plasma treatment, and wherein the main and branch line are pumped out via at least one pump.

58. Method as claimed in claim 57, **characterised in that** pressure regulation is performed by a pressure measuring device and a regulating valve connected in the main line, to regulate the pressure in the main line to a desired value in dependence upon the pressure measurement values recorded with the pressure measuring device.

59. Method as claimed in claim 58, **characterised in that** the pressure regulation is performed by means of a regulating valve which is disposed downstream of the branch in the branch line.

## Revendications

1. Substrat revêtu, **caractérisé par** un revêtement, en particulier un revêtement barrière, avec une pluralité de couches individuelles successives qui possèdent chacune une propriété qui est différente de celle d'une couche individuelle adjacente ou identique à celle-ci, dans lequel les couches individuelles présentent chacune une épaisseur de couche de 50 nanomètres au maximum, **caractérisé en ce que** le substrat est un tube obtenu par écrasement à chaud après le revêtement, en formant un espace vide fermé.

2. Substrat revêtu selon la revendication 1, **caractérisé en ce qu'**au moins une des couches individuelles, de préférence plusieurs couches individuelles, en particulier plusieurs couches individuelles successives, en particulier aussi toutes les couches individuelles du revêtement, en particulier du revêtement barrière, possèdent une épaisseur de couche de 10 nanomètres au maximum.

3. Substrat revêtu selon la revendication 1 ou 2, **caractérisé en ce qu'**au moins une des couches individuelles, de préférence plusieurs couches individuelles, en particulier plusieurs couches individuelles successives, en particulier aussi toutes les couches individuelles du revêtement, en particulier du revêtement barrière, possèdent une épaisseur de couche de 2 nanomètres au maximum, de préférence également inférieure à 2 nanomètres.

4. Substrat revêtu selon l'une des revendications précédentes, **caractérisé en ce qu'**au moins une couche individuelle du revêtement, en particulier du revêtement barrière, diffère d'une couche individuelle adjacente par sa composition chimique.

5. Substrat revêtu selon l'une des revendications précédentes, **caractérisé en ce qu'**au moins une des couches individuelles présente une structure cristalline, en particulier cristalline fine, ou semicristalline.

6. Substrat revêtu selon la revendication 5, **caractérisé par** une couche avec plusieurs couches cristallines successives de même nature.

7. Substrat revêtu selon l'une des revendications précédentes, **caractérisé en ce qu'**au moins une couche individuelle du revêtement, en particulier du revêtement barrière, diffère d'une couche individuelle adjacente par sa morphologie.

8. Substrat revêtu selon la revendication 7, **caractérisé en ce que** la couche individuelle diffère d'une couche individuelle adjacente par sa structure cristalline.

9. Substrat revêtu selon l'une des revendications précédentes, **caractérisé en ce que** le revêtement barrière comprend au moins un groupe élémentaire de couches avec des couches individuelles de même composition, mais de morphologie différente.

10. Substrat revêtu selon l'une des revendications précédentes, **caractérisé en ce que** les couches individuelles diffèrent par leur mode de croissance.

11. Substrat revêtu selon l'une des revendications précédentes, **caractérisé en ce qu'**au moins une des couches individuelles présente une structure amorphe ou au moins semi-amorphe.

12. Substrat revêtu selon la revendication 11, **caractérisé par** une couche avec plusieurs couches successives de même nature, au moins semi-amorphes.

13. Substrat revêtu selon l'une des revendications précédentes, **caractérisé en ce que** le revêtement, en particulier le revêtement barrière, comprend au moins un groupe élémentaire de couches avec des couches alternées aux propriétés différentes.

14. Substrat revêtu selon l'une des revendications précédentes, **caractérisé en ce que** le revêtement barrière comprend au moins un groupe élémentaire de couches avec des couches amorphes et des couches adjacentes au moins semicristallines, de préférence cristallines fines.

15. Substrat revêtu selon l'une des revendications précédentes, **caractérisé en ce que** le revêtement barrière comprend au moins un groupe élémentaire de couches avec deux couches au moins semicristallines, de préférence cristallines fines, de composition différente, entre lesquelles est disposée à chaque fois une couche amorphe.

16. Substrat revêtu selon l'une des revendications précédentes, **caractérisé en ce que** le revêtement, en particulier le revêtement barrière, est transparent.

17. Substrat revêtu selon l'une des revendications précédentes, **caractérisé par** un substrat transparent.

18. Substrat revêtu selon la revendication 16 ou 17, **caractérisé en ce que** la transparence du revêtement, en particulier du revêtement barrière, correspond à la transparence du substrat.

19. Substrat revêtu selon l'une des revendications 16 à 18, **caractérisé en ce que** la transmission lumineuse au travers d'un substrat revêtu diffère de la transmission lumineuse d'un substrat sans revêtement, en particulier sans revêtement barrière, d'un maximum de 5 % dans la partie visible du spectre.

20. Substrat revêtu selon l'une des revendications précédentes, **caractérisé en ce que** l'indice de réfraction du revêtement, en particulier du revêtement barrière, correspond à l'indice de réfraction de la surface du substrat ou diffère de celle-ci d'un maximum de 5 %.

21. Substrat revêtu selon l'une des revendications précédentes, **caractérisé par** un système de couche antireflet avec le revêtement, en particulier le revêtement barrière, dans lequel le système complet de couches a une action antireflet et au moins une couche du système de couche antireflet comprend un groupe élémentaire de couches composé d'une pluralité de couches successives avec une épaisseur moyenne des couches individuelles de 50 nanomètres au maximum dont l'indice de réfraction efficace est dimensionné de manière à ce que le système de couche antireflet ait globalement une action antireflet.

22. Substrat revêtu selon l'une des revendications précédentes, **caractérisé en ce qu'**au moins une des couches individuelles, de préférence toutes les couches individuelles, contiennent des oxydes anorganiques, en particulier des couches d'oxyde anorganique.

23. Substrat revêtu selon l'une des revendications précédentes, **caractérisé en ce qu'**au moins une des couches individuelles contient au moins l'un des oxydes suivants : Ti₂O, ZrO₂, SiO₂, Al₂O₃, Nb₂O₅, Ta₂O₅, HfO₂.

24. Substrat revêtu selon l'une des revendications précédentes, **caractérisé en ce que** le substrat comprend au moins l'un des matériaux suivants : verre, céramique vitreuse, céramique, métal, semiconducteur, matériau cristallin.

25. Substrat revêtu selon l'une des revendications précédentes, **caractérisé en ce que** le substrat est creux.

26. Substrat revêtu selon l'une des revendications précédentes, **caractérisé en ce que** le substrat a une forme tubulaire.

27. Substrat revêtu selon la revendication 25 ou 26, **caractérisé en ce que** le substrat est revêtu intérieurement.

28. Substrat revêtu selon l'une des revendications précédentes, **caractérisé en ce que** le revêtement a une action catalytique, en particulier photocatalytique.

29. Substrat revêtu selon la revendication 28, **caractérisé par** des couches individuelles à action photocatalytique contenant de l'oxyde de titane.

30. Catalyseur, en particulier filtre à air, comprenant un substrat selon l'une des revendications précédentes.

31. Procédé de fabrication d'un revêtement, en particulier d'un revêtement barrière, sur un substrat, en particulier de fabrication d'un substrat revêtu selon l'une des revendications précédentes, dans lequel sont déposées pour la fabrication du revêtement barrière une pluralité de couches individuelles successives qui possèdent chacune une propriété qui est différente de celle d'une couche individuelle adjacente ou identique à celle-ci et dont l'épaisseur de couche est de 50 nanomètres au maximum, **caractérisé en ce que** le substrat en forme de tube est revêtu puis est chauffé et écrasé après le revêtement.

32. Procédé selon la revendication 31, **caractérisé en ce qu'**au moins une des couches individuelles, de préférence plusieurs couches individuelles, en particulier plusieurs couches individuelles successives, en particulier aussi toutes les couches individuelles du revêtement, en particulier du revêtement barrière, sont déposées avec une épaisseur de couche de 10 nanomètres au maximum.

33. Procédé selon la revendication 31 ou 32, **caractérisé en ce qu'**au moins une des couches individuelles, de préférence plusieurs couches individuelles, en particulier plusieurs couches individuelles successives, en particulier aussi toutes les couches individuelles du revêtement barrière, sont déposées avec une épaisseur de couche de 2 nanomètres au maximum, de préférence également inférieure à 2 nanomètres.

34. Procédé selon l'une des revendications précédentes, **caractérisé en ce que** les couches individuelles sont déposées à l'aide d'au moins un procédé de dépôt sous vide.

35. Procédé selon la revendication 34, **caractérisé en ce qu'**au moins une partie des couches individuelles sont déposées par dépôt en phase vapeur activé par impulsions de plasma.

36. Procédé selon la revendication 34 ou 35, **caractérisé en ce qu'**au moins une partie des couches individuelles est déposée par pulvérisation.

37. Procédé selon l'une des revendications précédentes, **caractérisé en ce que** des couches successives de morphologie différente sont déposées en modifiant les paramètres du processus entre une couche et la couche suivante.

38. Procédé selon la revendication 37, **caractérisé en ce que** des couches individuelles à mode de croissance différent sont déposées en modifiant les paramètres du processus.

39. Procédé selon l'une des revendications précédentes, **caractérisé en ce que** l'on dépose au moins une couche individuelle amorphe.

40. Procédé selon l'une des revendications précédentes, **caractérisé en ce que** l'on dépose au moins une couche individuelle au moins semicristalline, de préférence cristalline fine.

41. Procédé selon l'une des revendications précédentes, **caractérisé en ce qu'**au moins un groupe élémentaire de couches du revêtement barrière est déposé avec des couches alternées de nature différente.

42. Procédé selon l'une des revendications précédentes, **caractérisé en ce qu'**au moins un groupe élémentaire de couches du revêtement barrière est déposé avec deux couches au moins semicristallines, de préférence cristallines fines de composition différente, entre lesquelles est disposée à chaque fois une couche amorphe.

43. Procédé selon l'une des revendications précédentes, **caractérisé en ce que**, entre les étapes de revêtement pour le dépôt des couches individuelles, on injecte une autre composition gazeuse que celle utilisée pour l'opération de revêtement, après quoi, en appliquant de l'énergie par un traitement plasma, on agit sur la morphologie d'une couche individuelle déposée par croissance auparavant.

44. Procédé selon la revendication 43, **caractérisé en ce que** l'on injecte pour le traitement plasma une composition gazeuse qui contient un gaz réactif.

45. Procédé selon la revendication 44, **caractérisé en ce que** l'on injecte pour le traitement plasma une composition gazeuse qui contient de l'oxygène gazeux.

46. Procédé selon l'une des revendications 43 à 45, **caractérisé en ce que** l'énergie électromagnétique pulsée pour le traitement plasma est utilisée pour la production du plasma.

47. Procédé selon l'une des revendications 43 à 46, **caractérisé en ce que**, par le traitement plasma, la couche individuelle est amenée à cristalliser partiellement ou totalement.

48. Procédé selon l'une des revendications 43 à 47, **caractérisé en ce qu'**une couche individuelle cristalline est déposée et est transformée par le traitement plasma en une couche individuelle au moins semi-amorphe.

49. Procédé selon l'une des revendications 43 à 48, **caractérisé en ce qu'**une couche individuelle cristalline est déposée et est transformée par le traitement plasma en une couche ayant une phase ou une morphologie cristalline différente.

50. Procédé selon l'une des revendications précédentes, dans lequel, pour la production de couches épaisses faites de couches individuelles différentes ou identiques ayant des épaisseurs de couche jusqu'à de préférence 50 nanomètres au maximum, les étapes de dépôt d'une couche individuelle et de traitement plasma de cette couche individuelle sont répétées plusieurs fois.

51. Procédé selon l'une des revendications précédentes, **caractérisé en ce que** l'on revêt un substrat creux, en particulier de forme tubulaire.

52. Procédé selon la revendication 51, **caractérisé en ce que** l'on revêt une ampoule de lampe.

53. Procédé selon la revendication 51 ou 52, **caractérisé en ce que** le substrat est revêtu intérieurement.

54. Procédé selon l'une des revendications 31 à 53, **caractérisé en ce qu'**une ampoule de lampe est produite par écrasement.

55. Procédé selon l'une des revendications précédentes, **caractérisé en ce que** l'on dépose des couches individuelles à action photocatalytique.

56. Procédé selon l'une des revendications précédentes, **caractérisé en ce que** l'on dépose des couches individuelles à action photocatalytique contenant de l'oxyde de titane.

57. Procédé selon l'une des revendications précédentes, pour un revêtement CVD de substrats activé par plasma, dans lequel le substrat est placé dans un réacteur, le gaz pour le revêtement plasma ou le traitement plasma étant introduit par une conduite secondaire raccordée à une conduite principale grâce à laquelle un système d'alimentation en gaz fournit le gaz ou le mélange gazeux pour le revêtement CVD et qui offre par rapport à la conduite secondaire avec le réacteur et le substrat qui y est placé une résistance moindre à l'écoulement et l'introduction d'énergie électromagnétique dans le gaz de processus au sein du réacteur produit un plasma pour le revêtement ou le traitement plasma, la conduite principale et la conduite secondaire étant pompées à l'aide d'au moins une pompe.

58. Procédé selon la revendication 57, **caractérisé en ce que** l'on réalise une régulation de la pression à l'aide d'un dispositif de mesure de la pression et d'une vanne de régulation montée sur la conduite principale, afin de régler la pression dans la conduite principale à une valeur de consigne en fonction des valeurs de mesure de la pression produites par le dispositif de mesure de la pression.

59. Procédé selon la revendication 58, **caractérisé en ce que** la régulation de la pression est opérée à l'aide d'une vanne de régulation placée après la dérivation de la conduite secondaire.
